# EUROPÄISCHE PATENTANMELDUNG

(11) **EP 4 482 282 A2**
(43) Veröffentlichungstag der Anmeldung: **25.12.2024**
(21) Anmeldenummer: 24204301.6
(22) Anmeldetag: 14.03.2018
(51) Int. Cl.: H10N 30/88

(54) **VORRICHTUNG ZUR ERZEUGUNG EINES NICHTTHERMISCHEN ATMOSPHÄRENDRUCK-PLASMAS UND WIRKRAUM**

(30) Priorität: 14.03.2017 DE 102017105430
(62) Teilanmeldung aus: 18711540.7
(71) Anmelder: Relyon Plasma GmbH, 93055 Regensburg (DE); TDK Electronics AG, 81671 München (DE)
(72) Erfinder: Pichler, Johann, 8614 Breitenau am Hochlantsch (AT); Kügerl, Georg, 8552 Eibiswald (AT); Puff, Markus, 8010 Graz (AT); Kudela, Pavol, 8530 Deutschlandsberg (AT); Nettesheim, Stefan, 93051 Regensburg (DE); Korzec, Dariusz, 93167 Falkenstein (DE); Burger, Dominik, 93055 Regensburg (DE)
(74) Vertreter: Epping - Hermann - Fischer

(57) **Zusammenfassung**

Die vorliegende Erfindung betrifft eine Vorrichtung zur Erzeugung eines nichtthermischen Atmosphärendruck-Plasmas, aufweisend ein erstes Gehäuse (11), in dem ein piezoelektrischer Transformator (1) angeordnet ist, und ein zweites Gehäuse (15), in dem eine Ansteuerschaltung (14) angeordnet ist, die dazu ausgestaltet ist, eine Eingangsspannung an den piezoelektrischen Transformator (1) anzulegen. Gemäß einem weiteren Aspekt betrifft die Erfindung einen Wirkraum, der die Vorrichtung und ein dichtes Gasvolumen oder ein undichtes Gasvolumen aufweist.

## Beschreibung

Die vorliegende Erfindung betrifft eine Vorrichtung zur Erzeugung eines nichtthermischen Atmosphärendruck-Plasmas. Ferner betrifft die vorliegende Erfindung einen Wirkraum, der eine solche Vorrichtung aufweist.

Das nichtthermische Atmosphärendruck-Plasma kann mit einem piezoelektrischen Transformator erzeugt werden. Bei dem Transformator kann es sich insbesondere um einen Transformator vom Rosen-Typ handeln.

Die Aufgabe der vorliegenden Erfindung ist es, eine verbesserte Vorrichtung zur Erzeugung von nichtthermischem Atmosphärendruck-Plasma anzugeben, die beispielsweise eine hohe Lebensdauer aufweist. Die Vorrichtung sollte vorzugsweise für den Einsatz in einem Wirkraum, beispielsweise einem Mülleimer, einem Mistkübel, einer Sporttasche, einem Kleiderschrank oder einem Kleidersack geeignet sein.

Diese Aufgabe wird durch eine Vorrichtung gemäß Anspruch 1 gelöst.

Es wird eine Vorrichtung zur Erzeugung eines nichtthermischen Atmosphärendruck-Plasmas vorgeschlagen, die ein erstes Gehäuse, in dem ein piezoelektrischer Transformator angeordnet ist, und ein zweites Gehäuse, in dem eine Ansteuerschaltung angeordnet ist, die dazu ausgestaltet ist, eine Eingangsspannung an den piezoelektrischen Transformator anzulegen, aufweist. Dementsprechend können der piezoelektrische Transformator und die Ansteuerschaltung durch das erste und das zweite Gehäuse räumlich voneinander getrennt sein.

Die Ansteuerschaltung weist eine Zeitschaltung auf, die die Eingangsspannung an den piezoelektrischen Transformator für eine vordefinierte Zeitspanne anlegt und die in einem vordefinierten Pausenintervall zwischen zwei Zeitspannen keine Eingangsspannung an den piezoelektrischen Transformator anlegt, wobei für die Dauer des Pausenintervalls das Anlegen der Eingangsspannung unterbunden wird. In dem Pausenintervall kann es somit nicht möglich sein, eine Eingangsspannung an den piezoelektrischen Transformator anzulegen. Dadurch kann eine Menge eines mit der Vorrichtung erzeugbaren Ozons auf ein nicht gesundheitsschädliches Maß begrenzt werden. Die Plasma- und Ozongenerierung kann in dem Pausenintervall nicht möglich sein.

Die Vorrichtung kann in einem gepulsten Betrieb betrieben werden, bei dem auf Basis der Zeitschaltung ohne Berücksichtigung anderer Betriebsparameter des Transformators der Transformator aktiviert und für die Dauer der Pausenintervalle deaktiviert werden kann. Die rein zeitbasierte Steuerung kann in jedem Fall eine Begrenzung der Ozongenerierungsrate auf ein gesundheitlich unbedenkliches Maß ermöglichen.

Diese Anordnung des piezoelektrischen Transformators in dem ersten Gehäuse und der Ansteuerschaltung in dem zweiten Gehäuse bringt zahlreiche Vorteile mit sich. Wird mit dem piezoelektrischen Transformator ein Plasma erzeugt, so können bei der Plasmaerzeugung Reizgase, beispielsweise Ozon, entstehen. Diese Reizgase sind zum Teil aggressiv und können im Laufe der Zeit die Ansteuerschaltung beschädigen. Da die Ansteuerschaltung jedoch hier in dem zweiten Gehäuse angeordnet ist, kann eine Beschädigung der Ansteuerschaltung durch die Reizgase verhindert werden. Dadurch kann die Lebensdauer der Vorrichtung erhöht werden. Das erste Gehäuse und das zweite Gehäuse können vorzugsweise derart ausgestaltet sein, dass ein Gasaustausch zwischen den beiden Gehäusen minimiert ist. Dementsprechend kann ein Reizgas, das in dem ersten Gehäuse erzeugt wird, nicht oder nur in einer vernachlässigbaren Konzentration in das zweite Gehäuse gelangen.

In dem Ausgangsbereich des piezoelektrischen Transformators können bei der Plasmaerzeugung elektrische Felder mit hohen Feldstärken entstehen. Durch die räumliche Trennung des piezoelektrischen Transformators und der Ansteuerschaltung kann sichergestellt werden, dass die Ansteuerschaltung nicht durch die elektrischen Felder in unerwünschter Weise beeinflusst wird.

Ferner kann durch die Anordnung des Transformators in dem ersten Gehäuse und die Anordnung der Ansteuerschaltung in dem zweiten Gehäuse ein Anwender besser vor Reizgasen geschützt werden. Der Anwender wird üblicherweise das zweite Gehäuse bedienen, um die Ansteuerschaltung einzuschalten oder Veränderungen in der Ansteuerung vorzunehmen. Da der piezoelektrische Transformator getrennt davon in dem ersten Gehäuse angeordnet ist, entstehen Reizgase nur in der Nähe des ersten Gehäuses und somit nicht in unmittelbarer Nähe des Anwenders. Dadurch kann die Sicherheit für den Anwender erhöht werden. Dadurch kann es ermöglicht werden, die Vorrichtung in Endprodukten für Endverbraucher einzusetzen, für die hohe Sicherheitsanforderungen gelten.

Durch die Aufteilung in separate Gehäuse kann die Vorrichtung leicht zu handhaben sein. Die Vorrichtung kann in kleiner und kompakter Weise konstruiert sein.

Bei dem hier verwendeten piezoelektrischen Transformator kann es sich beispielsweise um ein von EPCOS unter der Bezeichnung CeraPlas^{™} vertriebenes Bauteil handeln.

Der piezoelektrische Transformator kann dazu ausgestaltet sein, an einer ausgangsseitigen Stirnseite des piezoelektrischen Transformators ein piezoelektrisch gezündetes Mikroplasma zu erzeugen. Dabei kann es sich um sogenanntes Piezoelectric Direct Discharge Plasma (PDD) handeln. Das Plasma kann folglich unmittelbar am piezoelektrischen Transformator entstehen. Dabei ist keine zusätzliche dielektrische Barriere vor der ausgangsseitigen Stirnseite vorgesehen.

Alternativ kann eine dielektrische Barriere unmittelbar vor der ausgangsseitigen Stirnseite des Transformators angeordnet sein, wobei die Barriere beispielsweise von einem Aufsatz gebildet werden kann. In diesem Fall kann das Plasma ähnlich wie bei einer dielektrischen Barriereentladung (engl.: dielectric barriere discharge; DBD) erzeugt werden. Im Unterschied zu einer "klassisischen" dielektrischen Barriereentladung ist die Barriere jedoch nicht über ein Kabel mit einer Hochspannungsquelle verbunden, sondern befindet sich in unmittelbarer räumlicher Nähe zu dem piezoelektrischen Transformator, so dass eine von dem Transformator erzeugte Hochspannung kapazitiv in einen Zündraum, der von dem Transformator durch die Barriere getrennt ist, eingekoppelt werden kann.

Das erste und das zweite Gehäuse können separat voneinander sein. Die Gehäuse können nicht einstückig ausgebildet sind. Das erste Gehäuse ist nicht innerhalb des zweiten Gehäuses angeordnet und das zweite Gehäuse ist nicht innerhalb des ersten Gehäuses angeordnet. Die Gehäuse können räumlich voneinander getrennt sein. Die Gehäuse können nebeneinander angeordnet sein, wobei die beiden Gehäuse entweder unmittelbar aneinander anschließen oder in einem Abstand zueinander angeordnet sind. Das erste und das zweite Gehäuse können dazu ausgestaltet sein für eine räumliche Trennung zwischen dem piezoelektrischen Transformator und der Ansteuerschaltung zu sorgen. Das erste und das zweite Gehäuse können dazu ausgestaltet sein, dafür zu sorgen, dass ein Gasaustausch zwischen den beiden Gehäusen nur in einem zu vernachlässigenden Umfang erfolgt.

Die Ansteuerschaltung und der piezoelektrische Transformator können durch ein Kabel miteinander verbunden sein. Das Kabel kann es ermöglichen, eine von der Ansteuerschaltung ausgegebene Wechselspannung an die Außenelektroden des piezoelektrischen Transformators als Eingangsspannung anzulegen. Die Ansteuerschaltung kann derart ausgestaltet sein, dass sie nicht von der Impedanz des Kabels beeinflusst wird. Dementsprechend kann das Kabel eine Länge von bis zu 10 m aufweisen. Das Kabel kann eine Länge von mindestens 1 cm aufweisen. Das Kabel weist bevorzugt eine Länge in einem Bereich zwischen 10 cm und 100 cm auf.

In dem ersten Gehäuse kann ein Bedienelement angeordnet sein, das es ermöglicht, die Plasmaerzeugung zu steuern. Alternativ kann das Bedienelement in dem zweiten Gehäuse angeordnet sein. Bei dem Bedienelement kann es sich beispielsweise um einen Druckknopf, einen Drehregler, ein Mikrocontrollergesteuertes System mit oder ohne Touchscreen, eine Fernsteuerung oder ein System, das über USB, WLAN oder Bluetooth gesteuert wird, handeln. Ferner kann es sich um eine Steuerung mittels Software, beispielsweise einer App, handeln. Das Bedienelement kann es einem Nutzer der Vorrichtung ermöglichen, die Ansteuerschaltung anzusteuern und verschiedene Parameter bei der Plasmaerzeugung zu beeinflussen und auszulesen, beispielsweise die Eingangsspannung, die Menge des Prozessgases, das dem Transformator zugeführt wird, die Konzentration der Bestandteile des Prozessgases, die Eingangsleistung und die Betriebsdauer.

Ist das Bedienelement an dem zweiten Gehäuse angeordnet, ist es räumlich von dem piezoelektrischen Transformator, der sich im ersten Gehäuse befindet, getrennt. Dementsprechend kann die Sicherheit für einen Nutzer erhöht werden, der das Bedienelement betätigt, da er sich nicht in unmittelbarer Nähe des Transformators befinden muss, der möglicherweise gesundheitsschädliche Reizgase erzeugen kann.

Das erste Gehäuse kann eine Düse aufweisen, die vor einer Stirnseite des piezoelektrischen Transformators angeordnet ist und dazu ausgestaltet ist, einen vom piezoelektrischen Transformator erzeugten Plasmastrahl zu formen.

Ferner kann das erste Gehäuse eine dielektrische Barriere aufweisen, die unmittelbar vor dem piezoelektrischen Transformator angeordnet ist. Die dielektrische Barriere kann den piezoelektrischen Transformator von einem Zündungsraum, in dem das Prozessmedium angeordnet ist, trennen. Eine von dem piezoelektrischen Transformator erzeugte Hochspannung kann über die dielektrische Barriere kapazitiv in dem Zündungsraum eingekoppelt werden und dort eine Plasmazündung auslösen. Eine solche Ausführungsform ist insbesondere bei flüssigen Prozessmedien oder bei biologischem Gewebe als Prozessmedium vorteilhaft. In diesem Fall kommt der piezoelektrischen Transformator nicht unmittelbar mit dem Prozessmedium in Kontakt. Durch diesen unmittelbaren Kontakt würde der Transformator mechanisch gedämpft und könnte nicht mehr zur Erzeugung von Plasma verwendet werden. Da der unmittelbare Kontakt durch die Barriere verhindert wird, kann eine mechanische Dämpfung von vorne herein unterbunden werden. Auch bei anderen Prozessmedien, die sehr aggressiv sind und den piezoelektrischen Transformator beschädigen könnten, ist die Anordnung einer dielektrischen Barriere vor dem Transformator sinnvoll.

Die Vorrichtung kann ein drittes Gehäuse aufweisen, das einen ebenfalls piezoelektrischen Transformator aufweist. Das erste Gehäuse kann auswechselbar sein und durch das dritte Gehäuse ersetzt werden. In diesem Fall kann die Ansteuerschaltung nach dem Austausch des ersten Gehäuses durch das zweite Gehäuse dazu ausgestaltet sein, an den im dritten Gehäuse angeordneten piezoelektrischen Transformator die Eingangsspannung anzulegen.

Dementsprechend kann der piezoelektrische Transformator zusammen mit dem ersten Gehäuse ausgetauscht werden. Der piezoelektrische Transformator ist das Bauelement der Vorrichtung, das am stärksten Verschleißerscheinungen ausgesetzt ist. Durch die Ausführungsform, bei der das erste Gehäuse austauschbar ist, wird es ermöglicht, nur den Transformator zu ersetzen und die Ansteuerschaltung und weitere Elemente, die im zweiten Gehäuse angeordnet sind, weiter zu verwenden.

Der piezoelektrische Transformator kann dabei zusammen mit dem ersten Gehäuse als Modul ausgetauscht werden. Das erste Gehäuse und das zweite Gehäuse können miteinander durch eine lösbare Verbindung, beispielsweise eine Steckverbindung, eine USB-Verbindung oder eine Bajonettverbindung, verbunden sein. Eine solche Verbindung ist für einen Nutzer leicht zu lösen, sodass ein Austausch des Moduls aufweisend das erste Gehäuse und den piezoelektrischen Transformator in einfacher Weise vorgenommen werden kann. Ein Austausch des piezoelektrischen Transformators ohne gleichzeitigen Tausch des ersten Gehäuses wäre dagegen erheblich aufwendiger, da in diesem Fall die Befestigung des Transformators an dem Gehäuse gelöst werden müsste.

Das dritte Gehäuse kann eine Düse aufweisen. Das erste Gehäuse kann ebenfalls eine Düse aufweisen. Die Düsen können dazu ausgestaltet sein, den Plasmastrahl in unterschiedlicher Weise zu formen oder eine dielektrische Barriere vor dem Transformator anzubringen. Dementsprechend können das erste und das dritte Gehäuse gegeneinander ausgetauscht werden, um eine Form des Plasmastrahls in gewünschter Weise zu verändern. Ein separates Tauschen nur der Düse ohne dabei das gesamte erste Gehäuse zu tauschen wäre dagegen erheblich aufwendiger, da in diesem Fall die Befestigung der Düse an dem Gehäuse gelöst werden müsste und die neue Düse an dem Gehäuse wiederum befestigt werden müsste.

In einem alternativen Ausführungsbeispiel kann die Düse separat getauscht werden. Dabei kann eine am ersten Gehäuse oder am dritten Gehäuse angebrachte Düse wechselbar sein. Die Düse ist dabei vorzugsweise durch eine einfach zu lösende Befestigung an dem jeweiligen Gehäuse befestigt. Beispielsweise kann die Düse durch eine Bajonettverbindung an dem jeweiligen Gehäuse befestigt sein. Die Düse kann auch durch eine Rastverbindung oder eine Schraubverbindung an dem jeweiligen Gehäuse befestigt sein.

Das erste Gehäuse kann dazu ausgestaltet sein, bei der Plasmaerzeugung entstehende Reizgase zu vernichten. Zu diesem Zweck kann das erste Gehäuse eine Beschichtung aufweisen. Die Beschichtung kann beispielsweise Braunstein, Eisenoxid andere Metalloxide, blanke Metallflächen oder mit Metallkatalysatoren beschichtete Oberflächen oder Lacke aufweisen. Alternativ oder ergänzend kann das Gehäuse zur Vernichtung der Reizgase einen Filter aufweisen. Bei dem Filter kann es sich beispielsweise um einen Aktivkohlefilter handeln. Alternativ oder ergänzend kann das Gehäuse derart ausgestaltet sein, dass sich ein geschlossenes Gasführungssystem ergibt, bei dem verhindert wird, dass Reizgase aus dem Gehäuse austreten. Alternativ oder ergänzend kann das Gehäuse eine Saugvorrichtung aufweisen. Diese kann dazu ausgestaltet sein, Reizgase unmittelbar nach ihrer Erzeugung abzusaugen. Es kann ferner eine allenfalls nur teilweise Gasrückführung in das erste Gehäuse vorgesehen sein, wobei das erste Gehäuse zur Vernichtung der Reizgas entsprechend beschichtet sein kann.

Die Vorrichtung kann einen Regelmechanismus aufweisen, der es ermöglicht, eine Menge eines Prozessmediums, das dem piezoelektrischen Transformator zugeführt wird, einzustellen. Alternativ oder ergänzend kann es der Regelmechanismus auch ermöglichen, eine Zusammensetzung des Prozessmediums einzustellen.

Die Vorrichtung kann einen Aufsatz aufweisen, der an dem ersten Gehäuse befestigt ist und der eine dielektrische Barriere unmittelbar vor einer ausgangsseitigen Stirnseite des piezoelektrischen Transformators bildet, so dass die Vorrichtung dazu ausgestaltet ist, ein Plasma durch eine dielektrische Barriereentladung auf einer dem Transformator abgewandten Seite der dielektrischen Barriere zu zünden.

In dem ersten Gehäuse können mehrere piezoelektrische Transformatoren angeordnet sein. Die in dem zweiten Gehäuse angeordnete Ansteuerschaltung kann mit jedem der Transformatoren verbunden sein und dazu ausgestaltet sein, an jeden der Transformatoren eine Eingangsspannung anzulegen.

Die Ansteuerschaltung kann eine Zeitschaltung aufweisen, die die Eingangsspannung an den piezoelektrischen Transformator für eine vordefinierte Zeitspanne anlegt und die in einem vordefinierten Pausenintervall zwischen zwei Zeitspannen keine Eingangsspannung an den piezoelektrischen Transformator anlegt. Beispielsweise kann für eine Zeitspanne von 15 Sekunden eine Eingangsspannung an dem Transformator angelegt werden und in einem Pausenintervall von 2 Stunden keine Eingangsspannung angelegt werden. Auf diese Weise kann ein Energieverbrauch der Vorrichtung minimiert werden und die Reizgaskonzentration begrenzt werden.

Das erste Gehäuse und das zweite Gehäuse können durch zwei Kammern eines Spritzgussteils gebildet werden. Das erste Gehäuse und das zweite Gehäuse können wasserdicht voneinander getrennt sein. Das erste Gehäuse und das zweite Gehäuse können gasdicht voneinander getrennt sein.

In dem zweiten Gehäuse können Mittel zur Energieversorgung der Vorrichtung angeordnet sein. Bei den Mitteln zur Energieversorgung kann es sich beispielsweise um eine Batterie, aufladbare Akkus, die in einer Ausführungsform mittels kontaktlosem induktivem Laden aufgeladen werden können, oder einem Transformator handeln, der dazu ausgestaltet ist, eine Netzspannung in eine Betriebsspannung der Vorrichtung zu wandeln. Da die Mittel zur Energieversorgung in dem zweiten Gehäuse angeordnet sind, können sie weiterverwendet werden, wenn das erste Gehäuse ausgetauscht wird.

Bei der Vorrichtung kann es sich um ein tragbares Handgerät handeln.

In dem zweiten Gehäuse können Mittel zur Prozessgasversorgung angeordnet sein, wobei die Vorrichtung einen Schlauch aufweist, der dazu ausgestaltet ist, ein Prozessgas von den Mitteln zur Prozessgasversorgung aus dem zweiten Gehäuse zu dem in dem ersten Gehäuse angeordneten piezoelektrischen Transformator zu leiten. Der Schlauch kann in ein Kabel integriert sein, das das erste Gehäuse mit dem zweiten Gehäuse verbindet. Wird das erste Gehäuse ausgetauscht, können die Mittel zur Prozessgasversorgung somit weiterverwendet werden. Bei den Mitteln zur Prozessgasversorgung kann es sich beispielsweise um einen Ventilator, einen Kompressor oder einen Anschluss für verschiedene Druckgasbehälter, gegebenenfalls unter Verwendung eines Gasmischers, handeln. Ferner können die Mittel zur Prozessgasversorgung einen Druckminderer, einen Massenflusscontroller, einen Gasbefeuchter, einen Gastrockner, einen Zerstäuber sowie einen Vernebler aufweisen. Alternativ können die Mittel zur Prozessgasführung auch in das erste Gehäuse integriert sein.

Als Prozessmedium kann das Medium bezeichnet werden, in dem das Plasma gezündet wird. Bei dem Prozessmedium kann es sich beispielsweise um eine Umgebungsluft des piezoelektrischen Transformators handeln. Bei dem Prozessmedium kann es sich ferner um jeden bei der Verwendungstemperatur und dem Verwendungsdruck gasförmig vorliegende Stoff, sämtliche denkbaren bei der Verwendungstemperatur und dem Verwendungsdruck gasförmig vorliegenden Stoffgemische, ein Aerosol, das flüssige und/oder feste in Gas schwebende Teilchen aufweist, eine Flüssigkeit oder biologisches Gewebe handeln. Der Verwendungsdruck und die Verwendungstemperatur geben den Druck bzw. die Temperatur an, bei der die Vorrichtung zur Erzeugung des nichtthermischen Atmosphärendruck-Plasmas üblicherweise eingesetzt wird. Bei dem Verwendungsdruck kann es sich insbesondere um einen atmosphärischen Druck handeln. Der Verwendungsdruck kann zwischen 0,2 bar und 1,5 bar liegen, vorzugsweise zwischen 0,8 bar und 1,2 bar. Bei der Verwendungstemperatur kann es sich insbesondere um eine Raumtemperatur handeln. Die Verwendungstemperatur kann in einem Bereich zwischen -50°C und +155°C, vorzugsweise zwischen 0°C und 45°C, liegen.

Handelt es sich bei dem Prozessmedium um einen gasförmig vorliegenden Stoff, kann es sich beispielsweise um ein Reingas, z.B. reines He, reines Ar, reines N₂, reines O₂, reines CO₂, reines H₂ oder reines Cl₂ handeln. Ferner kann das Prozessmedium H₂O im überkritischen Bereich sein. Das Prozessmedium kann überkritische, d.h. bei Verwendungstemperatur und Verwendungsdruck nicht kondensierbare, Reinstoffe aufweisen.

Das Prozessmedium kann eines oder eine Mischung mehrerer der vorgenannten Reingase oder der folgenden Gase aufweisen: Luft, Schutzgas und Formiergas. Dabei ist das Prozessmedium so gewählt, dass bei Verwendungstemperatur und Verwendungsdruck der Gaszustand erhalten bleibt.

Das Prozessmedium kann ein Flüssigkeitsaerosol in einem Gas oder einem Gasgemisch aufweisen. Dabei kann es sich beispielsweise um Luft über dem Taupunkt, Sattdampf oder ein Benzin/Diesel-Luftgemisch handeln. Das Prozessmdium kann ein Feststoffsaerosol in einem Gas oder einem Gasgemisch aufweisen. Dabei kann es sich beispielsweise um Ruß in Abgas oder Feinstaub in Luft handeln. Für medizinische und technische Anwendungen können bei der Verwendung von Aerosolen als Prozessmedium besonders gute Resultate erzielt werden. Bei dem Aerosol kann es sich insbesondere um Wassertöpfchen in Luft handeln. Ferner kann es sich um Tröpfchen von H₂O₂ oder Formaldehyd handeln. Durch die Behandlung der Wassertröpfchen mit Plasma können OH Radikale erzeugt werden. Ferner können Wassertröpfchen dazu dienen, die entstehenden Reizgase, beispielsweise Ozon oder Stickoxid, zu binden und damit die Umgebungsbelastung mit diesen Gasen zu vermindern, um die Anwendungssicherheit zu erhöhen. Diese Reizgasbindung kann zusätzlich eine Wirkerhöhung durch Reizgas insbesondere zur Sterilisation bewirken, beispielsweise durch in Wassertröpfchen gelöstes Ozon. Die Vorrichtung könnte auch in Abgasströmen zur Partikelabscheidung verwendet werden. Die Vorrichtung könnte auch in Dampfkreisläufen oder Sanitärräumen sowie deren Lüftungskreisläufen verwendet werden, wobei ebenfalls Aerosole das Prozessmedium bilden können.

Die Vorrichtung kann einen Ansaugrüssel aufweisen, der dazu ausgestaltet ist, ein vom piezoelektrischen Transformator erzeugtes Reizgas abzusaugen, wobei das Reizgas in dem Ansaugrüssel vernichtet wird.

Die Vorrichtung kann einen Sensor zum Feststellen eines Füllstands, einer Temperatur oder einer Feuchtigkeit aufweisen. Der Sensor misst den entsprechenden Parameter im Innern oder in der Umgebung des Wirkraums.

Die Vorrichtung kann Schaltungskomponenten einer Fernsteuerung umfassen. Die Schaltungskomponenten dienen zum Ansteuern einer Ansteuerung. Die Fernsteuerung kann es über ein Programm oder eine App für einen Computer, z. B. einen PC oder ein mobile Kommunikationsgerät, ermöglichen, den Zustand der Vorrichtung auszulesen oder das Gerät zu steuern.

Die Vorrichtung kann Schaltungselemente zum Aufzeichnen von Parametern wie die Betriebsdauer, aufgetretene Fehler, Statusinformation oder anderer Betriebsparameter aufweisen. Mittels eines Speichers ist es möglich, Werte in einer Log-Datei zu erhalten.

Die Vorrichtung kann eine oder mehrere Anzeigen zum optischen oder akustischen Signalisieren eines oder mehrerer Betriebsparameter umfassen.

Die Vorrichtung kann dazu vorgesehen und geeignet sein, chemische Reaktionen zu ermöglichen, zu beschleunigen oder zu katalysieren.

Die Vorrichtung kann dazu vorgesehen und geeignet sein, Oberflächen zu aktivieren oder zu sterilisieren.

Die Vorrichtung kann dazu vorgesehen und geeignet sein, lebendiges und biologisches Gewebe zu behandeln oder zu reinigen. Insbesondere kann sie zur Behandlung oder zur Reinigung von offenen oder geschlossenen oder schlecht heilenden Wunden im Innern oder am Äußeren des lebenden menschlichen oder tierischen Körpers zu dienen. Insbesondere bevorzugt ist die Anwendung auf Hautwunden, wobei es sich bei diesen Wunden insbesondere um schlecht heilende, schlecht durchblutete oder mit Keimen infizierte Wunden handeln kann.

In dem ersten Gehäuse können ein Lüfter und ein Katalysator angeordnet sein, wobei der Lüfter dazu ausgestaltet ist, einen Umluftbetrieb zu bewirken, bei dem ein von dem piezoelektrischen Transformator ionisiertes Prozessmedium in dem ersten Gehäuse in einem Kreislauf geführt wird und dabei durch den Katalysator geführt wird, bevor das Prozessmedium erneut dem piezoelektrischen Transformator zugeführt wird.

Das erste Gehäuse kann einen Wärmetauscher aufweisen, der dazu angeordnet und ausgestaltet ist, Wärme aus dem Innern des ersten Gehäuses an eine Umgebung abzuführen.

Der Eingangsbereich des piezoelektrischen Transformators kann auf einem ersten Stützelement aufliegen, wobei die Vorrichtung zumindest einen Vorsprung aufweist, der einen Abstand zu dem piezoelektrischen Transformtor aufweist, wenn der Transformator sich in einem Ruhezustand befindet, und der einen Anschlag gegen Querbewegungen des piezoelektrischen Transformators bildet. Der Vorsprung kann auf halber Länge des Transformators angeordnet sein. Der Vorsprung kann einen Abstand zu dem piezoelektrischen Transformator aufweisen, wenn der Transformator sich in einem Ruhezustand befindet. Der Abstand des Vorsprungs ist dabei so gewählt, dass der piezoelektrische Transformator in seinem Ruhezustand auch bei üblichen Fertigungstoleranzen und bei thermischen Ausdehnungen nicht an den Vorsprung nicht anschlägt. Der Vorsprung ist derart angeordnet, dass er Bewegungen des Transformators auf Grund von Verformungen des Transformators im Betrieb und/oder auf Grund von Schlägen auf die Vorrichtung begrenzt und bei derartigen Bewegungen einen Anschlag für den Transformator bildet.

Die Vorrichtung kann einen zweiten Vorsprung aufweisen, der einen Abstand zu dem piezoelektrischen Transformtor aufweist, wenn der Transformator sich in einem Ruhezustand befindet, und der einen Anschlag gegen Querbewegungen des piezoelektrischen Transformators bildet, wobei der zweite Vorsprung an einem eingangsseitigen Ende des Transformators angeordnet ist. Der Abstand des zweiten Vorsprungs ist dabei so gewählt, dass der piezoelektrische Transformator in seinem Ruhezustand auch bei üblichen Fertigungstoleranzen und bei thermischen Ausdehnungen nicht an den zweiten Vorsprung nicht anschlägt. Der zweite Vorsprung ist derart angeordnet, dass er Bewegungen des Transformators auf Grund von Verformungen des Transformators im Betrieb und/oder auf Grund von Schlägen auf die Vorrichtung begrenzt und bei derartigen Bewegungen einen Anschlag für den Transformator bildet.

Gemäß einem weiteren Aspekt wird eine Vorrichtung zur Erzeugung eines nichtthermischen Atmosphärendruck-Plasmas vorgeschlagen, aufweisend ein erstes Gehäuse, in dem ein piezoelektrischer Transformator angeordnet ist, und ein zweites Gehäuse, in dem eine Ansteuerschaltung angeordnet ist, die dazu ausgestaltet ist, eine Eingangsspannung an den piezoelektrischen Transformator anzulegen, wobei das erste Gehäuse zur Vernichtung der Reizgase eine Beschichtung aufweist. Es kann sich bei der Beschichtung um Braunstein, Eisenoxid, andere Metalloxide, blanke Metallflächen oder mit Metallkatalysatoren beschichtete Oberfläche oder Lacke handeln.

Gemäß einem weiteren Aspekt wird eine Vorrichtung zur Erzeugung eines nichtthermischen Atmosphärendruck-Plasmas vorgeschlagen, aufweisend ein erstes Gehäuse, in dem ein piezoelektrischer Transformator angeordnet ist, und ein zweites Gehäuse, in dem eine Ansteuerschaltung angeordnet ist, die dazu ausgestaltet ist, eine Eingangsspannung an den piezoelektrischen Transformator anzulegen, und wobei in dem ersten Gehäuse zumindest ein Bedienelement angeordnet ist, das es ermöglicht, die Plasmaerzeugung zu steuern.

Gemäß einem weiteren Aspekt betrifft die vorliegende Erfindung einen Wirkraum, der die oben beschriebene Vorrichtung und ein Gasvolumen aufweist. Das Gasvolumen kann dicht oder undicht sein. Die Vorrichtung kann dabei dazu verwendet werden, dass in dem Gasvolumen vorhandene Gas mit Plasma und/oder Ozon zu behandeln, um beispielsweise einen Geruch zu vermeiden oder zu vermindern.

Der Wirkraum kann auch als Wirkvolumen bezeichnet werden. Der Wirkraum kann ein räumlich abgegrenzter Bereich sein, dessen Inhalt mit dem von der Vorrichtung erzeugten Plasma behandelt wird. Der Wirkraum kann dabei beispielsweise ein Behälter sein. Der Wirkraum muss nicht zwangsläufig ein abgeschlossenes Volumen aufweisen. Vielmehr kann bei einem Wirkraum mit einem undichten Gasvolumen ein ständiger Gasaustausch auftreten, so dass sich das in dem Wirkraum befindliche Gas kontinuierlich erneuert bzw. austauscht.

Ein Mistkübel, ein Mülleimer und ein Plastiksack können beispielsweise einen Wirkraum mit einem dichten Gasvolumen bilden. Eine Sporttasche oder ein Baumwollsack können einen Wirkraum mit einem undichten Gasvolumen bilden. Ferner ist die Verwendung in Schränken, beispielsweise Kleiderschränken, als Wirkraum denkbar. Auch die Verwendung in Kleidersäcken oder Schuhsäcken ist möglich.

Wird die Vorrichtung in einem Wirkraum mit einem undichten Gasvolumen eingesetzt, können vorzugsweise Vorkehrungen getroffen werden, um eine Reizgaskonzentration zu begrenzen und schnell abzubauen. Insbesondere kann das erste Gehäuse, das den Transformator aufweist, wie oben bereits diskutiert, dazu ausgestaltet sein, bei der Plasmaerzeugung entstehende Reizgase zu vernichten. Zu diesem Zweck kann das erste Gehäuse eine Beschichtung, beispielsweise Braunstein oder Eisenoxid, aufweisen. Alternativ oder ergänzend kann das Gehäuse zur Vernichtung der Reizgase einen Filter aufweisen. Alternativ oder ergänzend kann das Gehäuse derart ausgestaltet sein, dass sich ein geschlossenes Gasführungssystem ergibt, bei dem verhindert wird, dass Reizgase aus dem Gehäuse austreten. Alternativ oder ergänzend kann das Gehäuse eine Saugvorrichtung aufweisen, die dazu ausgestaltet ist, Reizgase unmittelbar nach ihrer Erzeugung abzusaugen. Alternativ kann das Gehäuse eine teilweise Reizgasführung oder (Gas-) Rückführung aufweisen, wobei das Gehäuse zur Vernichtung der Reizgase entsprechend beschichtet sein kann. Ferner kann die Vorrichtung eine akustische und/oder optische Warnvorrichtung aufweisen, die dazu ausgestaltet ist, einen Nutzer im Fall einer bedenklichen Reizgaskonzentration zu alarmieren. Alternativ oder ergänzend kann die Vorrichtung dazu ausgestaltet sein, bei einer Reizgaskonzentration, die über einem Schwellenwert liegt, automatisch abzuschalten. Die Vorrichtung kann ferner dazu ausgestaltet sein, sich wieder einzuschalten, wenn die Reizgaskonzentration unter den Schwellenwert gefallen ist.

Die Vorrichtung kann kompakt in dem Wirkraum integriert sein und eine Perforation zum Austritt von Ozon aufweisen. Die Vorrichtung kann aus dem Wirkraum entnehmbar sein. Alternativ kann auch nur das erste Gehäuse innerhalb des Wirkraums angebracht sein. Das zweite Gehäuse kann außerhalb des Wirkraums angeordnet sein.

Der Wirkraum kann zum Beispiel einen Deckel aufweisen, wobei die Vorrichtung oder zumindest das erste Gehäuse an dem Deckel angeordnet ist. Eine Plasmaaustrittsöffnung der Vorrichtung kann von dem Deckel weg weisen. Die Plasmaaustrittsöffnung weist in Richtung eines Wirkraums oder eines Wirkvolumens. Die Vorrichtung kann alternativ an einer anderen Position in dem Wirkraum eingebaut sein, beispielsweise in einer Seitenwand.

Die Vorrichtung kann eine Austrittsöffnung aufweisen, aus der vom Transformator erzeugtes Plasma austreten kann. Die Vorrichtung kann derart angeordnet sein, dass die Austrittsöffnung im Inneren des Wirkraums angeordnet ist. Die Vorrichtung kann ferner eine Eintrittsöffnung aufweisen, durch die ein gasförmiges Prozessmedium in das erste Gehäuse eindringen kann. Die Vorrichtung kann derart angeordnet sein, dass die Eintrittsöffnung außerhalb des Wirkraums angeordnet ist. Ferner kann die Vorrichtung einen Kohlefilter aufweisen, der zwischen der Eintrittsöffnung und der Austrittsöffnung angeordnet ist und der das Innere des Wirkraums von der Umgebung des Wirkraums trennt. Der Kohlefilter kann insbesondere verhindern, dass ein im Innern des Wirkraums erzeugtes Reizgas in die Umgebung des Wirkraums gelangt.

Alternativ oder ergänzend zum Kohlefilter kann die Vorrichtung, insbesondere zur Verhinderung eines Austritts des im Inneren des Wirkraums erzeugten Reizgases in die Umgebung des Wirkraums, mit einer Reizgas abbauenden Beschichtung versehen sein.

Der Wirkraum kann einen Sensor aufweisen, der dazu ausgestaltet ist, ein Öffnen oder Schließen des Deckels zu erkennen, wobei die Vorrichtung dazu ausgestaltet ist, nach dem Schließen des Deckels ein Plasma zu erzeugen. Bei dem Sensor kann es sich beispielsweise um einen Neigungssensor, einen Beschleunigungssensor oder einen Lichtsensor handeln.

Im Folgenden sind vorteilhafte Aspekte beschrieben. Um eine Referenzierung zu erleichtern sind die Aspekte
durchnummeriert. Merkmale der Aspekte sind nicht nur in Kombination mit dem speziellen Aspekt, auf den sie sich beziehen, sondern auch separat betrachtet relevant.
1. Vorrichtung zur Erzeugung eines nichtthermischen Atmosphärendruck-Plasmas, aufweisend
   ein erstes Gehäuse, in dem ein piezoelektrischer Transformator angeordnet ist, und
   ein zweites Gehäuse, in dem eine Ansteuerschaltung angeordnet ist, die dazu ausgestaltet ist, eine Eingangsspannung an den piezoelektrischen Transformator anzulegen.
2. Vorrichtung gemäß dem vorherigen Aspekt,
   wobei der piezoelektrische Transformator dazu ausgestaltet ist, an einer ausgangsseitigen Stirnseite des piezoelektrischen Transformators ein piezoelektrisch gezündetes Mikroplasma zu erzeugen.
3. Vorrichtung gemäß einem der vorherigen Aspekte,
   wobei das erste Gehäuse und das zweite Gehäuse separat voneinander sind.
4. Vorrichtung gemäß einem der vorherigen Aspekte,
   wobei die Ansteuerschaltung und der piezoelektrische Transformator durch ein Kabel miteinander verbunden sind.
5. Vorrichtung gemäß dem vorherigen Aspekt,
   wobei das Kabel eine Länge von mindestens 1 cm aufweist.
6. Vorrichtung gemäß einem der vorherigen Aspekte,
   wobei in dem ersten Gehäuse zumindest ein Bedienelement angeordnet ist, das es ermöglicht, die Plasmaerzeugung zu steuern,
      oder
   wobei in dem zweiten Gehäuse zumindest ein Bedienelement angeordnet ist, das es ermöglicht, die Plasmaerzeugung zu steuern.
7. Vorrichtung gemäß einem der vorherigen Aspekte,
   wobei das erste Gehäuse eine Düse aufweist, die vor einer Stirnseite des piezoelektrischen Transformators angeordnet ist und die dazu ausgestaltet ist, einen vom piezoelektrischen Transformator erzeugten Plasmastrahl zu formen.
8. Vorrichtung gemäß einem der vorherigen Aspekte,
   wobei die Vorrichtung ein drittes Gehäuse aufweist, das einen piezoelektrischen Transformator aufweist,
   wobei das erste Gehäuse auswechselbar ist und durch das dritte Gehäuse ersetzt werden kann.
9. Vorrichtung gemäß einem der vorherigen Aspekte,
   wobei das erste Gehäuse dazu ausgestaltet ist, bei der Plasmaerzeugung entstehende Reizgase zu vernichten.
10. Vorrichtung gemäß dem vorherigen Aspekt,
   wobei das erste Gehäuse zur Vernichtung der Reizgase eine Beschichtung und/oder einen Filter und/oder ein geschlossenes Gasführungssystem und/oder eine Saugvorrichtung aufweist.
11. Vorrichtung gemäß einem der vorherigen Aspekte,
   wobei die Vorrichtung einen Regelmechanismus aufweist, der es ermöglicht, die Menge und/oder eine Zusammensetzung eines Prozessmediums, das dem piezoelektrischen Transformator zugeführt wird, einzustellen.
12. Vorrichtung gemäß einem der vorherigen Aspekte,
   wobei die Vorrichtung einen Aufsatz aufweist, der an dem ersten Gehäuse befestigt ist und der eine dielektrische Barriere unmittelbar vor einer ausgangsseitigen Stirnseite des piezoelektrischen Transformators bildet, so dass die Vorrichtung dazu ausgestaltet ist, ein Plasma durch eine dielektrische Barriereentladung auf einer dem Transformator abgewandten Seite der dielektrischen Barriere zu zünden.
13. Vorrichtung gemäß einem der vorherigen Aspekte,
   wobei in dem ersten Gehäuse mehrere piezoelektrische Transformatoren angeordnet sind.
14. Vorrichtung gemäß einem der vorherigen Aspekte,
   wobei die Ansteuerschaltung eine Zeitschaltung aufweist, die die Eingangsspannung an den piezoelektrischen Transformator für eine vordefinierte Zeitspanne anlegt und die in einem vordefinierten Pausenintervall zwischen zwei Zeitspannen keine Eingangsspannung an den piezoelektrischen Transformator anlegt.
15. Vorrichtung gemäß einem der vorherigen Aspekte,
   wobei das erste Gehäuse und das zweite Gehäuse durch zwei Kammern eines Spritzgussteils gebildet werden.
16. Vorrichtung gemäß einem der vorherigen Aspekte,
   wobei das erste Gehäuse und das zweite Gehäuse wasserdicht voneinander getrennt sind.
17. Vorrichtung gemäß einem der vorherigen Aspekte,
   wobei das erste Gehäuse und das zweite Gehäuse gasdicht voneinander getrennt sind.
18. Vorrichtung gemäß einem der vorherigen Aspekte,
   wobei in dem zweiten Gehäuse eine Energieversorgung der Vorrichtung angeordnet ist.
19. Vorrichtung gemäß einem der vorherigen Aspekte,
   wobei es sich bei der Vorrichtung um ein tragbares Handgerät handelt.
20. Vorrichtung gemäß einem der vorherigen Aspekte,
   wobei in dem zweiten Gehäuse Mittel zur Prozessgasversorgung angeordnet sind,
   wobei die Vorrichtung einen Schlauch aufweist, der dazu ausgestaltet ist, ein Prozessgas von den Mitteln zur Prozessgasversorgung aus dem zweiten Gehäuse zu dem in dem ersten Gehäuse angeordneten piezoelektrischen Transformator zu leiten.
21. Vorrichtung gemäß einem der vorherigen Aspekte,
   wobei die Vorrichtung einen Ansaugrüssel aufweist, der dazu ausgestaltet ist, ein vom piezoelektrischen Transformator erzeugtes Reizgas abzusaugen, wobei das Reizgas in dem Ansaugrüssel vernichtet wird.
22. Vorrichtung gemäß einem der vorherigen Aspekte, ferner umfassend einen Sensor zum Feststellen eines Füllstands, einer Temperatur oder einer Feuchtigkeit im Innern oder in der Umgebung des Wirkraums.
23. Vorrichtung gemäß einem der vorherigen Aspekte, ferner umfassend Schaltungskomponenten einer Fernsteuerung zum Ansteuern einer Ansteuerung.
24. Vorrichtung gemäß einem der vorherigen Aspekte, ferner umfassend Schaltungselemente zum Aufzeichnen der Betriebsdauer, Fehler, Statusinformation, Betriebsparameter.
25. Vorrichtung gemäß einem der vorherigen Aspekte, ferner umfassend eine oder mehrere Anzeigen zum optischen oder akustischen Signalisieren eines oder mehrerer Betriebsparameter.
26. Vorrichtung gemäß einem der vorherigen Aspekte, zur Ermöglichung, Beschleunigung oder Katalyse von chemischen Reaktionen.
27. Vorrichtung gemäß einem der vorherigen Aspekte, die dazu vorgesehen ist, Oberflächen zu aktivieren oder zu sterilisieren.
28. Vorrichtung gemäß einem der vorherigen Aspekte, die dazu vorgesehen ist, Wunden eines menschlichen oder tierischen Körpers zu reinigen oder zu behandeln.
29. Wirkraum aufweisend eine Vorrichtung gemäß einem der vorherigen Aspekte und ein dichtes Gasvolumen oder ein undichtes Gasvolumen.
30. Wirkraum gemäß dem vorherigen Aspekt,
   wobei der Wirkraum einen Deckel aufweist und wobei die Vorrichtung an dem Deckel angeordnet ist, wobei eine Plasmaaustrittsöffnung der Vorrichtung von dem Deckel weg weist.
31. Wirkraum gemäß dem vorherigen Aspekt,
   wobei der Wirkraum einen Sensor aufweist, der dazu ausgestaltet ist, ein Öffnen und Schließen des Deckels zu erkennen, wobei die Vorrichtung dazu ausgestaltet ist, nach dem Schließen des Deckels Plasma zu erzeugen.

Im Folgenden wird die vorliegende Erfindung anhand der beiliegenden Figuren näher erläutert.
Figur 1 zeigt einen piezoelektrischen Transformator in einer perspektivischen Ansicht,
Figur 2 zeigt eine Vorrichtung zur Plasmaerzeugung gemäß einem ersten Ausführungsbeispiel,
Figur 3 zeigt einen piezoelektrischen Transformator, der in einer Halterung angeordnet ist,
Figur 4 zeigt eine Vorrichtung zur Plasmaerzeugung gemäß einem zweiten Ausführungsbeispiel,
die Figuren 5 bis 7 zeigen eine Vorrichtung zur Plasmaerzeugung gemäß einem dritten Ausführungsbeispiel,
Figur 8 zeigt einen ersten Teil einer Vorrichtung zur Plasmaerzeugung gemäß einer Variation des dritten Ausführungsbeispiels,
Figur 9 zeigt ein erstes Gehäuse gemäß einem weiteren Ausführungsbeispiel.
Figur 10 zeigt ein erstes Gehäuse gemäß einem weiteren Ausführungsbeispiel.
Die Figuren 11, 12 und 13 zeigen eine Halterung für einen piezoelektrischen Transformator.

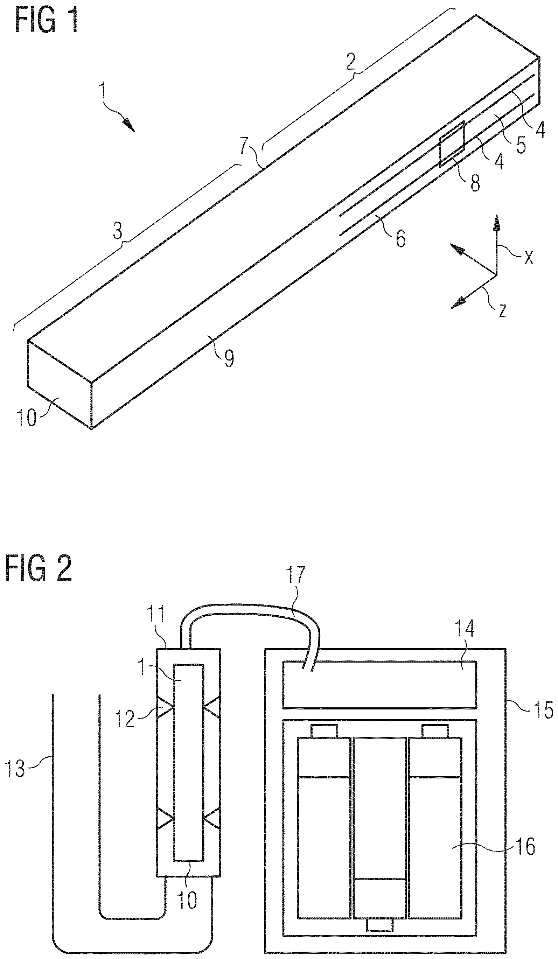

Figur 1 zeigt einen piezoelektrischen Transformator 1 in einer perspektivischen Ansicht. Der piezoelektrische Transformator 1 kann insbesondere in einer Vorrichtung zur Erzeugung von nichtthermischem Atmosphärendruck-Plasma eingesetzt werden.

Ein piezoelektrischer Transformator 1 ist eine Bauform eines Resonanztransformators, welcher auf Piezoelektrizität basiert und im Gegensatz zu den herkömmlichen magnetischen Transformatoren ein elektromechanisches System darstellt. Der piezoelektrische Transformator 1 ist beispielsweise ein Transformator vom Rosen-Typ.

Der piezoelektrische Transformator 1 weist einen Eingangsbereich 2 und einen Ausgangsbereich 3 auf, wobei der Ausgangsbereich 3 sich in einer Längsrichtung z an den Eingangsbereich 2 anschließt. Im Eingangsbereich 2 weist der piezoelektrische Transformator 1 Elektroden 4 auf, an die eine Wechselspannung angelegt werden kann. Die Elektroden 4 erstrecken sich in der Längsrichtung z des piezoelektrischen Transformators 1. Die Elektroden 4 sind in einer Stapelrichtung x, die senkrecht zu der Längsrichtung z ist, abwechselnd mit einem piezoelektrischen Material 5 gestapelt. Das piezoelektrische Material 5 ist dabei in Stapelrichtung x polarisiert.

Die Elektroden 4 sind im Innern des piezoelektrischen Transformators 1 angeordnet und werden auch als Innenelektroden bezeichnet. Der piezoelektrische Transformator 1 weist eine erste Seitenfläche 6 und eine zweite Seitenfläche 7, die der ersten Seitenfläche 6 gegenüberliegt, auf. Auf der ersten Seitenfläche 6 ist eine erste Außenelektrode 8 angeordnet. Auf der zweiten Seitenfläche 7 ist eine zweite Außenelektrode (nicht gezeigt) angeordnet. Die innenliegenden Elektroden 4 sind in Stapelrichtung x abwechselnd entweder mit der ersten Außenelektrode 8 oder der zweiten Außenelektrode elektrisch kontaktiert.

Der Eingangsbereich 2 kann mit einer geringen Wechselspannung angesteuert werden, die zwischen den Elektroden 4 angelegt wird. Aufgrund des piezoelektrischen Effekts wird die eingangsseitig angelegte Wechselspannung zunächst in eine mechanische Schwingung umgewandelt. Die Frequenz der mechanischen Schwingung ist dabei wesentlich von der Geometrie, dem mechanischen Aufbau sowie dem Material des piezoelektrischen Transformators 1 abhängig.

Der Ausgangsbereich 3 weist piezoelektrisches Material 9 auf und ist frei von innenliegenden Elektroden. Das piezoelektrische Material 9 im Ausgangsbereich 3 ist in der Längsrichtung x polarisiert. Bei dem piezoelektrischen Material 9 des Ausgangsbereichs 3 kann es sich um das gleiche Material wie bei dem piezoelektrischen Material 5 des Eingangsbereichs 2 handeln, wobei sich die piezoelektrischen Materialien 5 und 9 in ihrer Polarisationsrichtung unterscheiden können. Im Ausgangsbereich 3 ist das piezoelektrische Material 9 zu einer einzigen monolithischen Schicht geformt, die vollständig in der Längsrichtung z polarisiert ist. Dabei weist das piezoelektrische Material 9 im Ausgangsbereich 3 nur eine einzige Polarisationsrichtung auf.

Wird an die Elektroden 4 im Eingangsbereich 2 eine Wechselspannung angelegt, so bildet sich innerhalb des piezoelektrischen Materials 5, 9 eine mechanische Welle aus, die durch den piezoelektrischen Effekt im Ausgangsbereich 3 eine Ausgangsspannung erzeugt. Der Ausgangsbereich 3 weist eine ausgangsseitige Stirnseite 10 auf. Im Ausgangsbereich 3 wird somit eine elektrische Spannung zwischen der Stirnseite 10 und dem Ende der Elektroden 4 des Eingangsbereichs 2 erzeugt. An der ausgangsseitigen Stirnseite 10 wird dabei eine Hochspannung erzeugt. Dabei entsteht auch zwischen der ausgangseitigen Stirnseite und einer Umgebung des piezoelektrischen Transformators eine hohe Potentialdifferenz, die ausreicht, um ein starkes elektrisches Feld zu erzeugen, dass ein Prozessmedium ionisiert. Ferner ist die Erzeugung von Radikalen, angeregten Molekülen oder Atomen im Plasma möglich.

Auf diese Weise erzeugt der piezoelektrische Transformator 1 hohe elektrische Felder, die in der Lage sind, Gase oder Flüssigkeiten durch elektrische Anregung zu ionisieren. Dabei werden Atome oder Moleküle des jeweiligen Gases bzw. der jeweiligen Flüssigkeit ionisiert und bilden ein Plasma. Es kommt immer dann zu einer Ionisation, wenn die elektrische Feldstärke an der Oberfläche des piezoelektrischen Transformators 1 die Zündfeldstärke des Plasmas überschreitet. Als Zündfeldstärke eines Plasmas wird dabei die Feldstärke bezeichnet, die zur Ionisation der Atome oder Moleküle bzw. zur Erzeugung von Radikalen, angeregten Molekülen oder Atomen erforderlich ist.

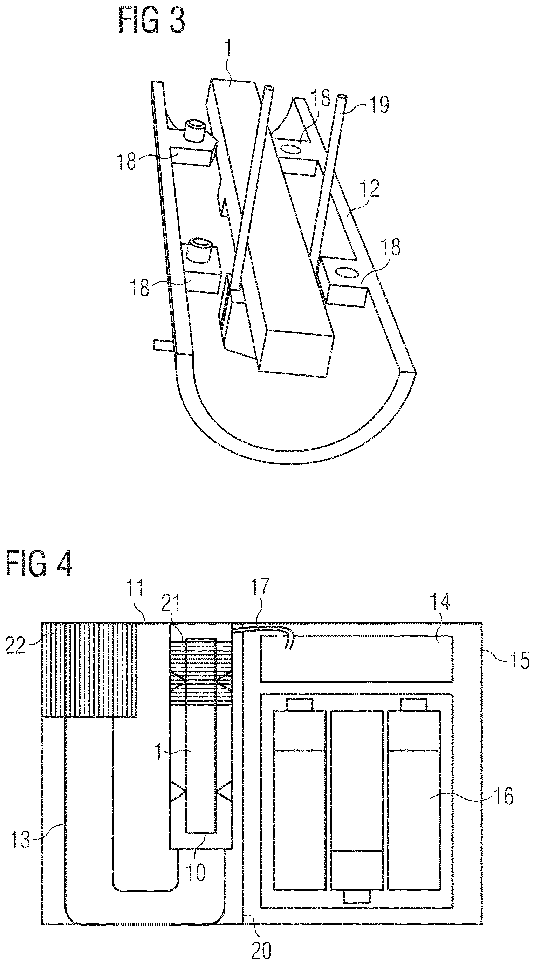

Figur 2 zeigt eine Vorrichtung zur Plasmaerzeugung, die den in Figur 1 gezeigten piezoelektrischen Transformator 1 aufweist. Die Vorrichtung weist ein erstes Gehäuse 11 auf, in dem der piezoelektrische Transformator 1 angeordnet ist. In dem Gehäuse 11 ist ferner eine Halterung 12 angeordnet, die den piezoelektrischen Transformator 1 befestigt. Die Halterung 12 wird später im Zusammenhang mit Figur 3 näher beschrieben.

Das erste Gehäuse 1 weist ferner einen Plasmaaustrittskanal 13 auf. Der Plasmaaustrittskanal 13 ist vor der ausgangsseitigen Stirnseite 10 des piezoelektrischen Transformators 1 angeordnet. Wird von dem piezoelektrischen Transformator 1 ein Prozessmedium ionisiert beziehungsweise werden von dem piezoelektrischen Transformator 1 Radikale, angeregte Moleküle oder Atome erzeugt, so wird ein auf diese Weise erzeugtes Plasma über den Plasmaaustrittskanal 13 zu einem gewünschten Einsatzort geleitet.

Der Plasmaaustrittskanal 13 ist eine optionale Ausgestaltung der Vorrichtung. Alternativ kann das erste Gehäuse 11 eine einfache Öffnung aufweisen, aus der das vom piezoelektrischen Transformator 1 erzeugte Plasma austreten kann. Alternativ kann das Gehäuse 11 eine Düse aufweisen, die dazu ausgestaltet ist, einen Plasmastrahl zu fokussieren oder aufzufächern oder die eine dielektrische Barriere aufweist.

Das erste Gehäuse 11 kann ferner einen Schalter zur Leistungs- und/oder Gasflussregelung aufweisen, der es ermöglicht einzustellen, welche Menge eines Prozessmediums dem piezoelektrischen Transformator 1 zugeführt wird. Das erste Gehäuse 11 kann einen Feedbackmechanismus aufweisen, der einer Ansteuerschaltung 14 Informationen über das aktuell erzeugte Plasma übermitteln kann, wobei die Ansteuerschaltung 14 ferner dazu ausgestaltet sein kann, die Ansteuerung des piezoelektrischen Transformators 1 unter Berücksichtigung dieser Informationen anzupassen.

Die Vorrichtung weist ferner ein zweites Gehäuse 15 auf. In dem zweiten Gehäuse 15 sind weitere Elemente der Vorrichtung angeordnet. Insbesondere ist eine Ansteuerschaltung 14 für den piezoelektrischen Transformator 1 in dem zweiten Gehäuse 15 angeordnet. In dem zweiten Gehäuse 15 ist ferner eine Energieversorgung 16 der Vorrichtung angeordnet.

Die Ansteuerschaltung 14 ist dazu ausgestaltet, an den piezoelektrischen Transformator 1 eine Eingangsspannung anzulegen. Die Ansteuerschaltung 14 ist mit dem piezoelektrischen Transformator 1 über ein Kabel 17 verbunden. Aufgrund der Ausgestaltung der Ansteuerschaltung 14 sind hinsichtlich der Kabellänge grundsätzlich keine wesentlichen Einschränkungen zu beachten. Ferner muss die Ansteuerschaltung 14 nicht durch eine separate Kühlvorrichtung oder einen Ventilator gekühlt werden. Eine Kühlvorrichtung kann jedoch alternativ vorgesehen sein, um allenfalls höhere Ausgangsleistungen zu erzielen.

Das Kabel 17, das die Ansteuerschaltung 14 mit dem piezoelektrischen Transformator 1 verbindet, kann mit dem ersten Gehäuse 11 entweder fest verbunden sein oder mit einer lösbaren Verbindung, beispielsweise einer Steckverbindung, verbunden sein. Ist das Kabel 17 mit einer lösbaren Verbindung mit dem ersten Gehäuse 11 verbunden, so kann das erste Gehäuse 11 beim Trennen der Verbindung komplett von dem zweiten Gehäuse 15 entfernt werden und beispielsweise durch ein anderes Gehäuse ersetzt werden. Das Kabel 17 kann ferner auch mit dem zweiten Gehäuse 15 entweder fest verbunden sein oder mit einer lösbaren Verbindung, beispielsweise einer Steckverbindung, verbunden sein.

In dem Kabel 17 kann ferner eine zusätzliche Leitung integriert sein, über die Informationen für einen Feedbackmechanismus von dem ersten Gehäuse 11 an das zweite Gehäuse 15 übermittelt werden. Diese Ausführungsform wird später genauer erläutert.

Alternativ oder ergänzend kann an dem Kabel 17 ein Bedienelement, beispielsweise ein Schalter, angeordnet sein, der es ermöglicht, einen Gasfluss zu regeln und auf diese Weise einzustellen, welche Menge eines gasförmigen Prozessmediums dem piezoelektrischen Transformator 1 zugeführt wird.

Alternativ oder ergänzend kann in dem Kabel 17 ein Schlauch integriert sein, über den ein Prozessmedium aus dem zweiten Gehäuse 15 in das erste Gehäuse 11 transportiert wird und auf diese Weise dem piezoelektrischen Transformator 1 zugeführt wird.

Bei der Energieversorgung 16 gemäß dem in Figur 2 gezeigten Ausführungsbeispiel handelt es sich um Batterien. Bei der Energieversorgung 16 kann es sich auch um aufladbare Akkus handeln. Diese können optional durch ein induktives Ladeverfahren geladen werden. Alternativ kann es sich bei der Energieversorgung 16 auch um einen Transformator handeln, der dazu ausgestaltet ist, mit einem Stromnetz verbunden zu werden und die Netzspannung des Stromnetzwerkes auf eine Betriebsspannung der Vorrichtung zu transformieren.

Das erste und das zweite Gehäuse 11, 15 sind räumlich voneinander getrennt. Durch die räumliche Trennung des ersten und des zweiten Gehäuses 11, 15 kann sichergestellt werden, dass ein Gasaustausch zwischen den beiden Gehäusen 11, 15 minimiert wird. Dementsprechend kann ein im ersten Gehäuse 11 erzeugtes Gas nicht oder zumindest nur in einer vernachlässigbar geringen Konzentration in das zweite Gehäuse 15 eindringen. Auf diese Weise wird die im zweiten Gehäuse 15 angeordnete Ansteuerschaltung 14 von bei der Plasmaerzeugung im ersten Gehäuse 11 entstehenden Reizgasen geschützt. Da die Ansteuerschaltung 14 nicht mit möglicherweise aggressiven Reizgasen in unmittelbaren Kontakt kommt, haben diese keinen negativen Einfluss auf die Lebensdauer der Vorrichtung. Dementsprechend ermöglicht die räumliche Trennung der beiden Gehäuse 11, 15 eine hohe Lebensdauer der Vorrichtung.

Ferner ermöglicht es die räumliche Trennung des piezoelektrischen Transformators 1 und der Ansteuerschaltung 14 und die damit verbundene Minimierung des Gasaustausches zwischen den beiden Gehäusen, die Vorrichtung auch in ein Consumerprodukt zu integrieren. Als Consumerprodukt wird ein Produkt bezeichnet, das von einem Endkunden beispielsweise im privaten Gebrauch verwendet wird. Hierbei sind besondere Sicherheitsanforderungen zu erfüllen, gemäß denen ein Nutzer der Vorrichtung vor möglicherweise gesundheitsschädlichen Reizgasen geschützt werden muss. Es wäre beispielsweise möglich, dass zweite Gehäuse 15 mit der Ansteuerschaltung 14 und mit Bedienelementen in einem für den Endnutzer zugänglichen Bereich anzuordnen und das erste Gehäuse 11, das den piezoelektrischen Transformator 1 aufweist und in dem potentiell gesundheitsschädliche Reizgase entstehen können, in einem für den Endnutzer nicht unmittelbar zugänglichen Bereich anzuordnen. Dementsprechend kann der Endnutzer durch die räumliche Trennung des piezoelektrischen Transformators 1 und der Ansteuerschaltung 14 vor den Reizgasen geschützt werden.

Da es die Ansteuerschaltung 14 ermöglicht, auf separate Kühlung zu verzichten, wird insgesamt die Konstruktion eines kleinen und leichten Handgerätes, in dem die Vorrichtung integriert ist, ermöglicht.

Im Ausgangsbereich 3 des piezoelektrischen Transformators 1 entstehen bei der Plasmaerzeugung elektrische Felder mit hohen Feldstärken. Durch die räumliche Trennung des piezoelektrischen Transformators 1 und der Ansteuerschaltung 14 in zwei separaten Gehäusen 11, 15 kann sichergestellt werden, dass die Ansteuerschaltung 14 nicht durch die elektrischen Felder gestört werden kann.

In das zweite Gehäuse 15 können ferner weitere Elemente der Vorrichtung integriert sein. Beispielsweise können Bedienelemente in dem zweiten Gehäuse 15 untergebracht sein. Die Bedienelemente können es ermöglichen, der Ansteuerschaltung 14 Befehle zu erteilen und auf diese Weise die Plasmaerzeugung durch den piezoelektrischen Transformator 1 zu steuern. Bei den Bedienelementen kann es sich um Druckknöpfe, Drehregler, durch Mikrocontroller gesteuerte Systeme mit einem Touchscreen, durch einen Mikrocontroller gesteuerte Systeme ohne Touchscreen, eine Fernsteuerung oder Systeme handeln, die über USB, WLAN oder Bluetooth mit der Ansteuerschaltung verbindbar sind und dieser Steuerungsbefehle übermitteln können. Alternativ oder ergänzend kann die Ansteuerschaltung mittels einer App oder einer anderen Software bedient werden. Die Bedienelemente können auch an dem Kabel 17, das das erste und das zweite Gehäuse 11, 15 miteinander verbindet, angeordnet sein.

In dem zweiten Gehäuse 15 kann ferner eine Gasversorgung integriert sein, die dazu ausgestaltet ist, ein gasförmiges Prozessmedium zu dem piezoelektrischen Transformator 1 zu leiten. In das Kabel 17, das das erste Gehäuse 11 mit dem zweiten Gehäuse 15 verbindet, kann ferner ein Schlauch integriert sein, über den das gasförmige Prozessmedium in das erste Gehäuse 11 eingeleitet wird.

Die Gasversorgung kann beispielsweise einen Ventilator aufweisen. Die Gasversorgung kann einen Kompressor aufweisen.

Die Gasversorgung kann Anschlüsse aufweisen, an die verschiedene Druckgasbehälter angeschlossen werden können. Zur Mischung verschiedener Gase kann die Gasversorgung ferner einen Gasmischer aufweisen. Die Gasversorgung kann einen Druckminderer und/oder Massendurchflussregler (englisch Mass flow controller = MFC), der es ermöglicht, die Menge des Prozessmediums zu regeln, aufweisen. Ferner kann die Gasversorgung einen Gasbefeuchter oder einen Gastrockner oder einen Vernebler oder einen Zerstäuber aufweisen. Ferner ist denkbar die Gasregelung mit einer stationär vorhandenen Gasversorgung über entsprechende Kuppelungen zu verbinden und hiermit die Versorgung zu ermöglichen. Bei der stationär vorhandenen Gasversorgung kann es sich beispielsweise um eine Pressluftquelle oder um Gasdruckleitungen handeln, die beispielsweise N₂, O₂ oder Ar liefern.

Die Ansteuerschaltung 14 kann dazu ausgestaltet sein, eine Leistung- und/oder Gasflusskonzentration zu regeln. Die Ansteuerschaltung 14 kann die an den piezoelektrischen Transformator 1 angelegte Eingangsspannung und/oder das Prozessmedium, das dem piezoelektrischen Transformator 1 zugeführt wird, variieren. Hinsichtlich des Prozessmediums sind Variationen der Menge des zugeführten Prozessmediums sowie der Zusammensetzung des zugeführten Prozessmediums möglich. Beispielsweise kann die Vorrichtung mehrere Gaskartuschen aufweisen, in denen unterschiedliche Gase angeordnet sind. Das Prozessmedium kann sich aus einer Mischung dieser Gase ergeben. Durch eine Variation des Mischverhältnisses der Gase können die Eigenschaften des erzeugten Plasmas verändert werden.

Die Vorrichtung kann einen Sensor aufweisen, der beispielsweise eine von dem piezoelektrischen Transformator 1 erzeugte Ozonmenge erfasst. Die Ansteuerschaltung 14 kann dazu ausgestaltet sein, unter Berücksichtigung der vom Sensor gemessenen Werte zumindest einen der folgenden Parameter zu variieren und/oder auszulesen: die Eingangsspannung, die Menge des dem Transformator 1 zugeführten Prozessmedium, die Zusammensetzung des Prozessmediums, die Eingangsleistung und die Betriebsdauer.

Alternativ oder ergänzend kann die Vorrichtung dazu ausgestaltet sein, zu erkennen, ob eine Last in unmittelbarer Nähe des Transformators 1 angeordnet ist. Die Ansteuerschaltung 14 kann dazu ausgestaltet sein, bei Detektion einer Last zumindest einen der folgenden Parameter zu variieren: die Eingangsspannung, die Menge des dem Transformator zugeführten Prozessmedium, die Zusammensetzung des Prozessmediums, die Eingangsleistung und die Betriebsdauer.

Das zweite Gehäuse 15 kann ferner eine Statusanzeige aufweisen. Die Statusanzeige kann beispielsweise eine Leuchtdiode aufweisen. Unterschiedliche Farben oder unterschiedliche Blinkmuster der Leuchtdiode können Informationen über den Betriebszustand oder den Batteriestatus der Vorrichtung übermitteln. Die Statusanzeige kann eine Zustands- und/oder Leistungsüberwachung der Vorrichtung ermöglichen.

Die Vorrichtung kann ferner ein optisches und/oder akustisches Reizgaswarnsystem aufweisen, das einen Nutzer warnt, sofern in der unmittelbaren Nähe der Vorrichtung ein vorgegebener Grenzwert für eine Reizgaskonzentration überschritten wird.

In einem nicht gezeigten Ausführungsbeispiel können in dem ersten Gehäuse 11 mehrere piezoelektrische Transformatoren 1 angeordnet sein. Die Ansteuerschaltung 14 kann dazu ausgelegt sein, an jeden der Transformatoren 1 eine Eingangsspannung anzulegen. Die piezoelektrischen Transformatoren 1 können parallel zueinander betrieben werden. Auf diese Weise kann die Menge eines erzeugten Plasmas erhöht werden.

Figur 3 zeigt den piezoelektrischen Transformator 1, der in der Halterung 12 befestigt ist. Die Halterung 12 weist Stützelemente 18 auf, die in der Längsrichtung z bei einer Länge von einem Viertel und von drei Vierteln der Gesamtlänge des piezoelektrischen Transformators 1 angeordnet sind und linienförmig an diesem anliegen. Ferner weist die Halterung 12 zwei Kontaktelemente 19 auf, die mit den Außenelektroden des piezoelektrischen Transformators 1 elektrisch verbunden sind. Bei den Kontaktelementen 19 handelt es sich zum Beispiel um Drähte oder um Bleche beispielsweise aus Kupfer, Invar, Kupfer-Invar-Kupfer (CIC) oder Edelstahl. Die Kontaktelemente 19 können am piezoelektrischen Transformator 1 befestigt sein und mit der Halterung 12 eine formschlüssige Verbindung bilden. Auf diese Weise kann eine Bewegung des Transformators 1 in die Längsrichtung z relativ zu der Halterung 12 verhindert werden.

Alternativ zu der hier gezeigten Befestigung in der Halterung 12 kann der piezoelektrische Transformator 1 auch zusammen mit einem Gebläse und/oder einer Prozessgaszuführung in einem Modul angeordnet sein. Ein solches Modul kann im ersten Gehäuse 11 angeordnet sein.

Figur 4 zeigt ein zweites Ausführungsbeispiel der Vorrichtung, wobei das erste Gehäuse 11 und das zweite Gehäuse 15 unmittelbar nebeneinander angeordnet sind. Die beiden Gehäuse sind durch eine gemeinsame Trennwand 20 voneinander getrennt. Die Trennwand 20 sorgt für eine räumliche Trennung des im ersten Gehäuse 11 angeordneten Transformators 1 von den im zweiten Gehäuse 15 angeordneten Elementen, insbesondere der Ansteuerschaltung 14 und der Energieversorgung 16.

Das erste Gehäuse 11 weist hier ferner eine erste Öffnung 21 auf, über die eine Umgebungsluft als Prozessmedium dem piezoelektrischen Transformator 1 zugeführt werden kann. Die erste Öffnung 21 ist ein schlitzförmiges Gitter. Das erste Gehäuse 11 weist ferner eine zweite Öffnung 22 auf, über die ein von dem piezoelektrischen Transformator 1 erzeugtes Plasma aus dem ersten Gehäuse 11 austreten kann. Auch die zweite Öffnung 22 ist ein schlitzförmiges Gitter. Die erste Öffnung 21 und die zweite Öffnung 22 können jeweils entweder an einer Oberseite oder einer Unterseite des ersten Gehäuses 11 angeordnet sein. Die zweite Öffnung 22 ist am Ende des Plasmaaustrittskanals 13 angeordnet.

Ansonsten entspricht die in Figur 4 gezeigte Vorrichtung im Wesentlichen der in Figur 2 gezeigten Vorrichtung.

Zwischen der ersten Öffnung 21 des ersten Gehäuses 11 und dem piezoelektrischen Transformator 1 kann ferner ein Aktivkohlefilter (nicht gezeigt) angeordnet sein. Der Aktivkohlefilter nimmt Ozon auf und baut das Ozon schnell und effektiv ab. Die erste Öffnung 21 bildet eine Zuströmöffnung, über die das gasförmige Prozessmedium zu dem piezoelektrischen Transformator 1 hinströmt. Sollte sich der Gasfluss innerhalb des ersten Gehäuses 11 jedoch umkehren, so kann der Aktivkohlefilter verhindern, dass Ozon aus der ersten Öffnung 21 austritt. Dementsprechend erhöht der Aktivkohlefilter die Sicherheit des Nutzers bei etwaigen Fehlfunktionen der Vorrichtung.

Die Vorrichtung kann ferner dazu ausgestaltet sein, den Austritt von möglicherweise gesundheitsschädlichem Reizgas aus der zweiten Öffnung 22 zu verhindern. Dazu kann die Vorrichtung mit einer Beschichtung, beispielsweise aus Braunstein oder Eisenoxid, versehen sein, die Ozon abbaut. Die Beschichtung kann beispielsweise auf der Innenseite des Plasmaaustrittskanals 13 aufgetragen sein. Alternativ kann der Austritt von Ozon auch durch ein Filtersystem verhindert werden, das an der ausgangsseitigen Stirnseite 10 des piezoelektrischen Transformators 1 angeordnet ist. Alternativ kann da Prozessmedium auch in einem geschlossenen Kreislauf geführt werden, um den Austritt des Ozons zu verhindern. Alternativ kann es auch möglich sein, dass die Vorrichtung derart ausgestaltet ist, dass ein Fluss des Prozessmediums umgekehrt werden kann um in einem Saugbetrieb das Reizgas abzusaugen.

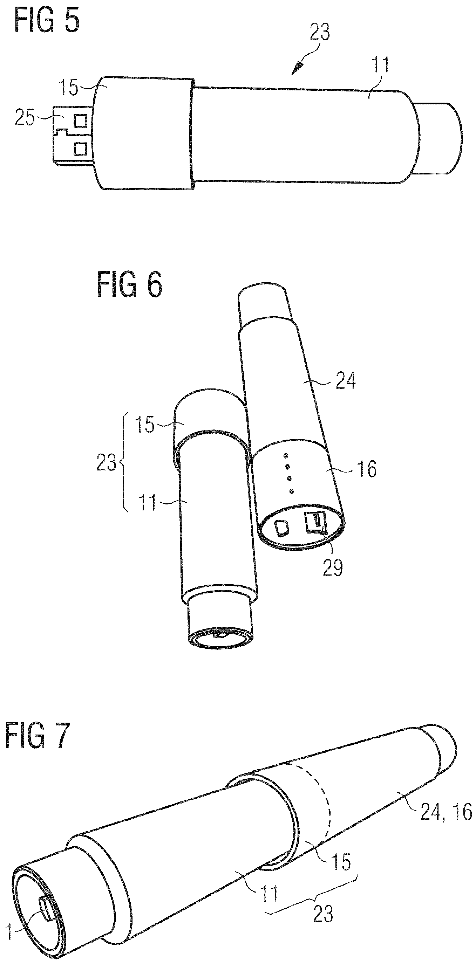

Die Figuren 5, 6 und 7 zeigen die Vorrichtung gemäß einem weiteren Ausführungsbeispiel. Die Vorrichtung weist zwei Teile auf. Insbesondere weist die Vorrichtung einen ersten Teil 23 auf, der aus einem ersten Gehäuse 11 und einem zweiten Gehäuse 15 besteht, und einen zweiten Teil 24, der aus einer Energieversorgung 16 besteht, auf.

Figur 5 zeigt den ersten Teil 23 der Vorrichtung. Das erste Gehäuse 11 weist den piezoelektrischen Transformator 1 auf. Das zweite Gehäuse 15 weist die Ansteuerschaltung 14 auf. Das erste Gehäuse 11 und das zweite Gehäuse 15 sind nicht lösbar miteinander verbunden. Eine nicht lösbare Verbindung bezeichnet hierbei eine Verbindung, die nicht lösbar ist, ohne das erste und/oder das zweite Gehäuse 11, 15 zu beschädigen. Das erste und das zweite Gehäuse 11, 15 sind dabei räumlich voneinander getrennt. Dementsprechend sind der piezoelektrische Transformator 1 und die Ansteuerschaltung 14 räumlich voneinander getrennt.

Das zweite Gehäuse 15 weist einen USB Stecker 25 auf, der es ermöglicht, den ersten Teil 23 mit dem zweiten Teil 24 zu verbinden. Insbesondere kann die Ansteuerschaltung 14 über den USB Stecker 25 mit der Energieversorgung 16 verbunden werden.

Figur 6 zeigt den ersten und den zweiten Teil 23, 24 der Vorrichtung, wobei die beiden Teile 23, 24 nicht miteinander verbunden sind. Figur 7 zeigt den ersten und den zweiten Teil 23, 24 der Vorrichtung, wobei die beiden Teile 23, 24 nicht miteinander verbunden sind.

Der zweite Teil 24 besteht aus der Energieversorgung 16. Die Energieversorgung 16 weist eine USB Stecker Aufnahme 29 auf, die dazu ausgestaltet ist, mit dem USB Stecker 25 des ersten Teils 23 verbunden zu werden. Der zweite Teil 24 kann mit dem ersten Teil 23 durch eine USB-Steckverbindung verbunden werden. Sind die beiden Teile 23, 24 miteinander verbunden, wird die Ansteuerschaltung 14 durch die Energieversorgung 16 mit einer Spannung versorgt. In alternativen Ausführungsformen können der erste und der zweite Teil 23, 24 durch eine andere Steckverbindung, beispielsweise eine Bajonettverbindung, miteinander verbunden werden.

Das zweite Gehäuse 15 weist keinen eingebauten Akku, keine Ladeelektronik und keinen DC/DC Wandler auf. Dementsprechend kann der erste Teil 23 der Vorrichtung klein und kompakt sein. Der erste Teil 23 der Vorrichtung kann unempfindlich gegen Stoßbelastungen sein.

Der erste Teil 23 der Vorrichtung kann dazu ausgestaltet sein, über den USB Stecker 25 mit einem beliebigen USB Zubehör verbunden zu werden. Beispielsweise kann ein USB Verlängerungskabel, ein USB Ständer, eine USB Powerbank oder ein USB Netzteil an den ersten Teil 23 angeschlossen werden. Ferner kann die Ansteuerschaltung 14 über den USB Stecker 25 an eine USB Schnittstelle eines Computers angeschlossen werden. Dabei kann über den Computer eine Konfiguration der Vorrichtung vorgenommen werden. Alternativ oder ergänzend zu der hier beschriebenen USB Verbindung sind auch andere genormte Niederspannungselemente oder -systeme denkbar zur Verbindung des ersten Teils 23 mit weiterem Zubehör, beispielsweise Mikro-USB.

Die in den Figuren 5 bis 7 gezeigte Vorrichtung bietet den Vorteil, dass der erste Teil 23 der Vorrichtung leicht austauschbar ist. Die Energieversorgung 16 kann vom ersten Teil 23 der Vorrichtung getrennt werden und mit einem anderen Teil verbunden werden, das ebenfalls einen piezoelektrischen Transformator 1 und eine Ansteuerschaltung 14 in separaten Gehäusen 11, 15 aufweist.

Der erste Teil 23, aufweisend den piezoelektrischen Transformator 1 und die Ansteuerschaltung 14, kann als Modul ausgetauscht werden. Dabei kann der erste Teil 23 durch ein anderes Gehäuse ersetzt werden, welches ebenfalls einen piezoelektrischen Transformator 1 und eine Ansteuerschaltung 14 aufweist. Der piezoelektrische Transformator 1 ist das Bauteil der Vorrichtung, das den größten Verschleißerscheinungen unterliegt. Durch das Austauschen des ersten Teils 23 als Modul wird es ermöglicht, den piezoelektrischen Transformator 1 durch einen neuen Transformator zu ersetzen, ohne dabei die gesamte Vorrichtung ersetzen zu müssen. Insbesondere kann die Energieversorgung 16 weiterverwendet werden. Durch das Austauschen des ersten Teils 23 als Modul kann der Austausch in einfacher Weise vorgenommen werden und beispielsweise durch einen Endkunden durchgeführt werden.

Der erste Teil 23 kann durch einen baugleichen Teil ersetzt werden. Alternativ kann der erste Teil durch einen Teil ersetzt werden, bei dem eine Düse vorgesehen ist, die dazu ausgestaltet ist, einen von der Vorrichtung erzeugten Plasmastrahl zu formen oder eine dielektrische Barriere auszubilden.

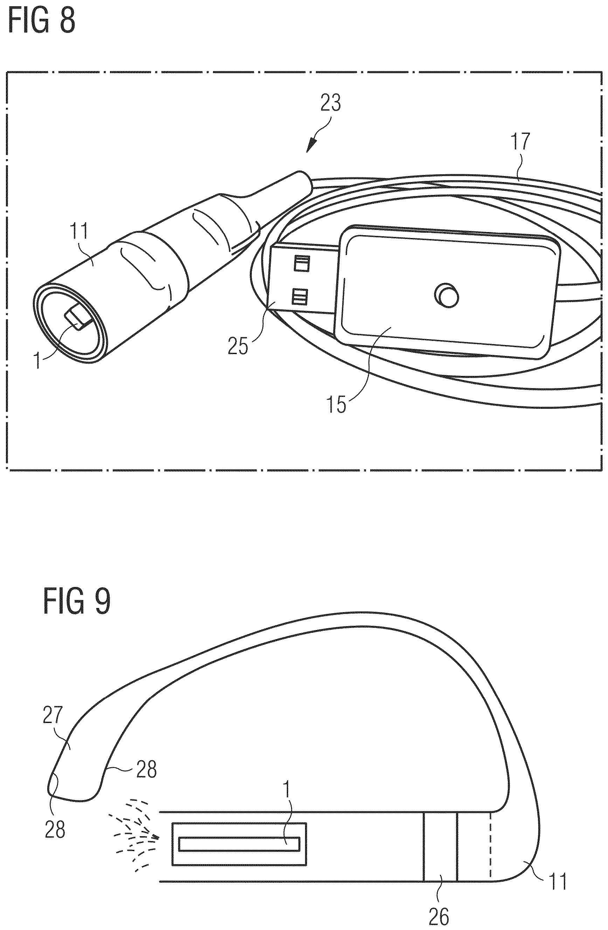

Figur 8 zeigt eine alternative Ausgestaltung des ersten Teils 23 der Vorrichtung. Der erste Teil 23 weist hier ein erstes Gehäuse 11, in dem der piezoelektrische Transformator 1 angeordnet ist, und ein zweites Gehäuse 15 auf, in dem die Ansteuerschaltung 14 angeordnet ist. Das zweite Gehäuse 15 weist einen USB Stecker 25 auf. Über den USB Stecker 25 kann das zweite Gehäuse 15 mit der Energieversorgung 16 verbunden werden. Das erste Gehäuse 11 und das zweite Gehäuse 15 sind über das Kabel 17 miteinander verbunden.

Figur 9 zeigt ein weiteres Ausführungsbeispiel der Vorrichtung. In Figur 9 ist lediglich das erste Gehäuse 11 gezeigt, dass den piezoelektrischen Transformator 1 aufweist. Das erste Gehäuse 11 ist als tragbares Handgerät ausgestaltet.

Das erste Gehäuse 11 weist ferner einen Ventilator 26 auf, der als Prozessmediumszufuhr dient. Das Handgerät weist ferner einen Ansaugrüssel 27 auf, in den Luft eingesaugt wird. Der Ansaugrüssel 27 ist nahe einer Plasmaaustrittsöffnung des ersten Gehäuses 11 angeordnet. Die Innenseite des Ansaugrüssels 27 ist mit einer Ozon abbauende Beschichtung 28, beispielsweise aus Braunstein oder Eisenoxid, beschichtet. Reizgase, die bei der Plasmaerzeugung zwangsläufig entstehen, werden über den Ansaugrüssel 27 eingesaugt, sodass das Ozon schnell und effektiv abgebaut werden kann.

Das erste Gehäuse 11 kann ferner eine Düse oder einen Düsenaufsatz aufweisen, der die Form des von dem piezoelektrischen Transformator 1 erzeugten Plasmastrahls gestaltet. Die Düse kann beispielsweise dazu ausgestaltet sein, den Plasmastrahl aufzufächern oder den Plasmastrahl zu fokussieren.

Das erste Gehäuse 11 kann mit einem zweiten Gehäuse 15, das die Ansteuerschaltung 14 aufweist, verbunden werden. Diese Verbindung der beiden Gehäuse 11, 14 ist lösbar.

Das erste Gehäuse 11, aufweisend den piezoelektrischen Transformator 1 und die Düse, können aus der Vorrichtung herausgenommen werden und als Modul ausgetauscht werden. Dabei kann das erste Gehäuse durch ein drittes Gehäuse ersetzt werden, welches ebenfalls einen piezoelektrischen Transformator 1 und eine Düse aufweist. Der piezoelektrische Transformator 1 ist das Bauteil der Vorrichtung, das den größten Verschleißerscheinungen unterliegt. Durch das Austauschen des ersten Gehäuses als Modul wird es ermöglicht, den piezoelektrischen Transformator 1 durch einen neuen Transformator zu ersetzen, ohne dabei weitere im zweiten Gehäuse angeordnete Elemente tauschen zu müssen. Beispielsweise kann die Ansteuerschaltung 14 weiterverwendet werden. Durch das Austauschen des ersten Gehäuses als Modul kann der Austausch in einfacher Weise vorgenommen werden und beispielsweise durch einen Endkunden durchgeführt werden.

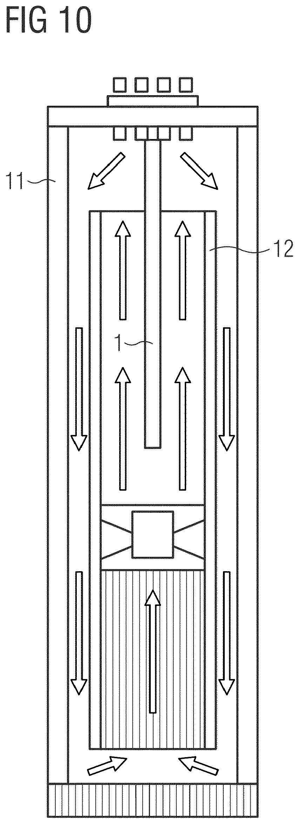

Figur 10 zeigt das erste Gehäuse 11 gemäß einem weiteren Ausführungsbeispiel. In dem ersten Gehäuse 11 ist der piezoelektrische Transformator 1 angeordnet.

Das erste Gehäuse 11 weist eine Öffnung auf, die durch eine Koppelplatte 30 verschlossen ist. Die Koppelplatte 30 weist ein nicht-leitendes Material auf. Die Koppelplatte 30 bildet eine dielektrische Barriere, wobei Plasma auf der Außenseite der Koppelplatte 30 gezündet werden kann.

Auf der Seite der Koppelplatte 30, die von dem piezoelektrischen Transformator 1 weg weist ist eine Metallisierung 38 angeordnet. Die Metallisierung 38 beeinflusst das vom piezoelektrischen Transformator 1 erzeugte elektrische Feld. Auf diese Weise kann die Form eines auf der Außenseite der Koppelplatte 30 gezündeten Plasmas beeinflusst werden. Durch eine entsprechende Formgebung der Metallisierung 38 kann das Plasma gebündelt oder aufgefächert werden.

Die Vorrichtung kann einen Satz von Koppelplatten 30 aufweisen, die jeweils mit dem ersten Gehäuse 11 verbindbar sind. Die Koppelplatten 30 unterscheiden sich dabei jeweils in der Form ihrer Metallisierungen 38. Beispielsweise kann die Vorrichtung eine erste Koppelplatte 30 aufweisen, die eine Metallisierung aufweist, die zu einer Bündelung eines Plasmastrahls auf der Außenseite der ersten Koppelplatte 30 führt. Ferner kann die Vorrichtung eine zweite Koppelplatte 30 aufweisen, die eine andersgeformte Metallisierung aufweist, die zu einer Auffächerung eines Plasmastrahls auf der Außenseite der ersten Koppelplatte 30 führt. Abhängig von der Anwendung der Vorrichtung kann das erste Gehäuse 11 entweder mit der ersten Koppelplatte 30 oder mit der zweiten Koppelplatte 30 verbunden werden. Die Koppelplatten 30 können austauschbar sein.

In dem ersten Gehäuse sind ferner ein Lüfter 31, ein Katalysator 32 und ein Wärmetauscher 33 angeordnet. Das erste Gehäuse 11 weist ferner ein röhrenförmiges Gehäuseelement 34 auf, in dem der piezoelektrische Transformator 1 angeordnet ist. Auch der Lüfter 31 und der Katalysator 32 sind in dem röhrenförmigen Gehäuseelement 34 angeordnet.

Der Lüfter 32 ist dazu ausgestaltet, einen Umluftbetrieb innerhalb des ersten Gehäuses 11 zu bewirken. Dabei wird Luft oder ein anderes Prozessmedium an dem piezoelektrischen Transformator 1 entlanggeführt, tritt dann aus dem röhrenförmigen Gehäuseelement 34 aus und wird an einer Rückseite des röhrenförmigen Gehäuseelementes 34 wieder in dieses eingezogen. Die Strömung des Prozessmediums ist in Figur 10 durch Pfeile eingezeichnet. In Flussrichtung des Prozessmediums bei Umluftbetrieb sind der Katalysator 32, der Lüfter 31 und der piezoelektrische Transformator 1 in dieser Reihenfolge in dem röhrenförmigen Gehäuseelement 34 angeordnet. Der Katalysator 32 ist dabei derart angeordnet, dass das Prozessmedium zunächst durch den Katalysator 32 geführt wird, bevor es erneut den piezoelektrischen Transformator 1 erreicht.

Der Katalysator 32 ist dazu ausgestaltet ein Reizgas, insbesondere Ozon, abzubauen. Bei dem Katalysator 32 kann es sich beispielsweise um einen Aktivkohlefilter handeln. Alternativ oder ergänzend zu dem Aktivkohlefilter kann der Katalysator einen auf Braunstein basierenden Filter bzw. einen MnO₂ basierten Filter aufweisen. Braunstein kann dabei in Form einer Beschichtung vorliegen.

An dem piezoelektrischen Transformator 1 wird das Prozessmedium ionisiert. Dabei werden Ozon und Plasma generiert. Auch außerhalb des ersten Gehäuses 11 wird Plasma erzeugt durch eine dielektrische Barriereentladung durch die Koppelplatte 30 hindurch. Das Ozon und andere Reizgase verbleiben innerhalb des ersten Gehäuses 11 und werden aufgrund des Umluftbetriebs zu dem Katalysator 32 zugeführt und dort abgebaut.

Bei Betrieb des piezoelektrischen Transformators 1 wird dieser erhitzt, sodass nicht unerhebliche Wärme von dem Transformator 1 an das Innere des Gehäuses 11 abgegeben wird. Auch bei der Ionisation des Prozessmediums entsteht weitere Hitze innerhalb des ersten Gehäuses 11. Um eine Überhitzung des Inneren des ersten Gehäuses 11 zu verhindern, weist das erste Gehäuse 11 einen Wärmetauscher 35 auf. Der Wärmetauscher 35 ist an dem der Koppelplatte 30 gegenüberliegenden Ende des ersten Gehäuses 11 angeordnet. Der Wärmetauscher 35 ist dazu ausgestaltet, in dem ersten Gehäuse 11 befindliche Hitze an eine Umgebung abzugeben.

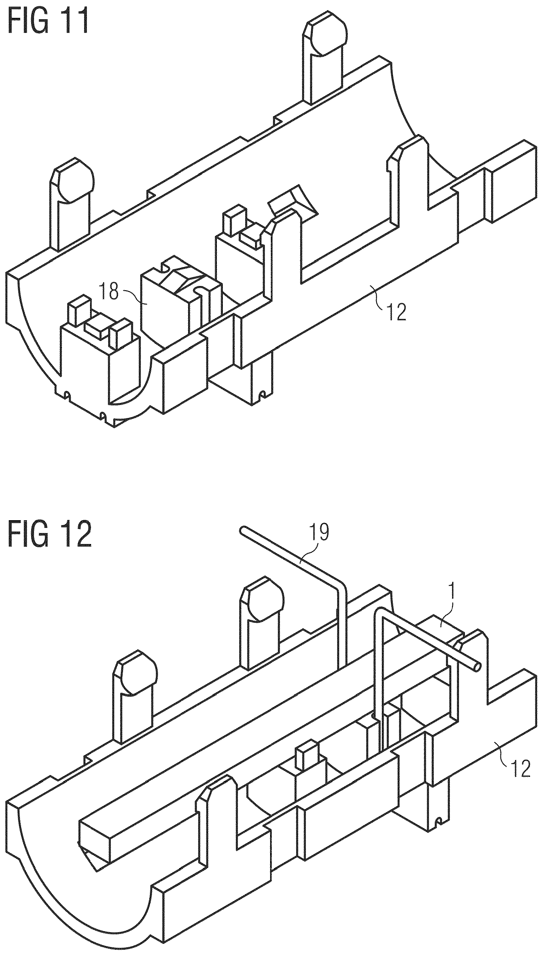

Die Figuren 11 bis 13 zeigen eine alternative Ausgestaltung der in Figur 3 gezeigten Halterung 12, an der der piezoelektrische Transformator 1 befestigt werden kann. Die Halterung 12 besteht aus zwei identischen, miteinander verbindbaren Halbschalen 12a, 12b.

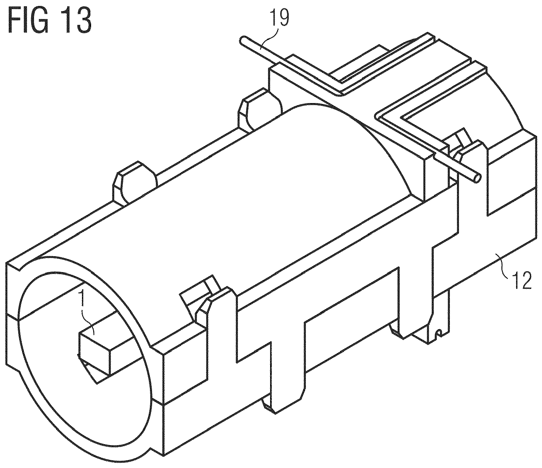

Figur 11 zeigt eine erste Halbschale 12a der Halterung 12. Figur 12 zeigt ebenfalls die erste Halbschale 12a der Halterung 12, wobei ferner der piezoelektrische Transformator 1 und zwei Kontaktelemente 19 zu seiner Kontaktierung gezeigt sind. Figur 13 zeigt beide Halbschalen 12a, 12b der Halterung 12 sowie den in der Halterung 12 befestigten piezoelektrischen Transformator 1 und die Kontaktelemente 19 zu seiner Kontaktierung.

Im Gegensatz zu der in Figur 3 gezeigten Halterung 12 weist die in den Figuren 11 bis 13 gezeigte Halterung 12 nur ein Stützelement 18 auf, auf dem der piezoelektrische Transformator 1 in seinem Ruhezustand aufliegt. Als Ruhezustand wird dabei ein Zustand bezeichnet, an dem keine elektrische Spannung an dem Transformator 1 anliegt und bei dem keine externen Kräfte, beispielsweise infolge eines Stoßes auf die Vorrichtung einwirken. Das Stützelement 18 ist in Längsrichtung bei einer Länge von einem Viertel der Gesamtlänge des Transformators 1 angeordnet. Das Stützelement 18 läuft keilförmig zu, sodass der Transformator 1 linienförmig auf dem Stützelement 18 aufliegt. Die Kontaktelemente 19 sind an dem ersten Stützelement 18 angeordnet und befestigt.

Die Vorrichtung weist keine Stützelemente 18 auf, die sich im Ausgangsbereich des piezoelektrischen Transformators 1 befinden.

Die Vorrichtung weist ferner zwei Vorsprünge 36, 37 auf, die gegenüber dem piezoelektrischen Transformator 1 einen Abstand von wenigen Mikrometern haben, wenn der Transformator 1 sich in seinem Ruhezustand befindet. Wird der Transformator 1 infolge einer Querbewegung, beispielsweise aufgrund eines Stoßes oder infolge einer Verformung durch eine angelegte Spannung, bewegt, schlägt er gegen einen oder beide der Vorsprünge 36, 37 an, die somit die Querbelastung des Transformators 1 begrenzen und einen mechanischen Anschlag gegen Querbewegungen des Transformators 1 ausbilden. Ein erster Vorsprung 36 ist in der Mitte des Transformators 1 angeordnet. Der zweite Vorsprung 37 ist an dem eingangsseitigen Ende des Transformators 1 angeordnet.

### Bezugszeichenliste

- 1: piezoelektrischer Transformator
- 2: Eingangsbereich
- 3: Ausgangsbereich
- 4: Elektrode
- 5: piezoelektrisches Material
- 6: erste Seitenfläche
- 7: zweite Seitenfläche
- 8: erste Außenelektrode
- 9: piezoelektrisches Material
- 10: ausgangsseitige Stirnseite
- 11: erstes Gehäuse
- 12: Halterung
- 12a: erste Halbschale
- 12b: zweite Halbschale
- 13: Plasmaaustrittskanal
- 14: Ansteuerschaltung
- 15: zweites Gehäuse
- 16: Energieversorgung
- 17: Kabel
- 18: Stützelement
- 19: Kontaktelement
- 20: Trennwand
- 21: erste Öffnung
- 22: zweite Öffnung
- 23: erster Teil
- 24: zweiter Teil
- 25: USB Stecker
- 26: Ventilator
- 27: Ansaugrüssel
- 28: Beschichtung
- 29: USB Stecker Aufnahme
- 30: Koppelplatte
- 31: Lüfter
- 32: Katalysator
- 33: Wärmetauscher
- 34: röhrenförmiges Gehäuseelement
- 35: Wärmetauscher
- 36: Vorsprung
- 37: Vorsprung
- x: Stapelrichtung
- z: Längsrichtung

## Patentansprüche

1. Vorrichtung zur Erzeugung eines nichtthermischen Atmosphärendruck-Plasmas, aufweisend
ein erstes Gehäuse (11), in dem ein piezoelektrischer Transformator (1) angeordnet ist, und
ein zweites Gehäuse (15), in dem eine Ansteuerschaltung (14) angeordnet ist, die dazu ausgestaltet ist, eine Eingangsspannung an den piezoelektrischen Transformator (1) anzulegen.

2. Vorrichtung gemäß dem vorherigen Anspruch,
wobei das erste Gehäuse (11) eine Düse aufweist und die Düse separat getauscht werden kann.

3. Vorrichtung gemäß dem vorherigen Anspruch,
wobei die Düse vor einer Stirnseite (10) des piezoelektrischen Transformators (1) angeordnet ist und dazu ausgestaltet ist, einen vom piezoelektrischen Transformator (1) erzeugten Plasmastrahl zu formen.

4. Vorrichtung gemäß Anspruch 2 oder Anspruch 3,
wobei die Düse dazu ausgestaltet ist, einen Plasmastrahl zu fokussieren oder aufzufächern.

5. Vorrichtung gemäß einem der Ansprüche 2 bis 4,
wobei die Düse durch eine einfach zu lösende Befestigung an dem ersten Gehäuse (11) befestigt ist.

6. Vorrichtung gemäß einem der Ansprüche 2 bis 5,
wobei die Düse durch eine Bajonettverbindung an dem ersten Gehäuse (11) befestigt ist.

7. Vorrichtung gemäß einem der Ansprüche 2 bis 6,
wobei die Düse durch eine Rastverbindung oder eine Schraubverbindung an dem ersten Gehäuse (11) befestigt ist.

8. Vorrichtung gemäß einem der vorherigen Ansprüche,
wobei die Ansteuerschaltung (14) eine Zeitschaltung aufweist, die die Eingangsspannung an den piezoelektrischen Transformator (1) für eine vordefinierte Zeitspanne anlegt und die in einem vordefinierten Pausenintervall zwischen zwei Zeitspannen keine Eingangsspannung an den piezoelektrischen Transformator (1) anlegt, wobei für die Dauer des Pausenintervalls das Anlegen der Eingangsspannung unterbunden wird.

9. Vorrichtung gemäß einem der vorherigen Ansprüche,
wobei die Vorrichtung einen Aufsatz aufweist, der an dem ersten Gehäuse (11) befestigt ist und der eine dielektrische Barriere unmittelbar vor einer ausgangsseitigen Stirnseite (10) des piezoelektrischen Transformators (1) bildet, so dass die Vorrichtung dazu ausgestaltet ist, ein Plasma durch eine dielektrische Barriereentladung auf einer dem Transformator (1) abgewandten Seite der dielektrischen Barriere zu zünden.

10. Vorrichtung gemäß einem der vorherigen Ansprüche,
wobei es sich bei der Vorrichtung um ein tragbares Handgerät handelt.

11. Vorrichtung gemäß einem der vorherigen Ansprüche, ferner umfassend Schaltungselemente zum Aufzeichnen von Parametern wie der Betriebsdauer, aufgetretenen Fehlern, Statusinformation oder anderen Betriebsparameter.

12. Vorrichtung gemäß einem der vorherigen Ansprüche, ferner umfassend eine oder mehrere Anzeigen zum optischen oder akustischen Signalisieren eines oder mehrerer Betriebsparameter.

13. Vorrichtung gemäß einem der vorherigen Ansprüche, zur Ermöglichung, Beschleunigung oder Katalyse von chemischen Reaktionen.

14. Vorrichtung gemäß einem der vorherigen Ansprüche, die dazu vorgesehen ist, Oberflächen zu aktivieren oder zu sterilisieren.

15. Vorrichtung gemäß einem der vorherigen Ansprüche, die dazu vorgesehen ist, Wunden eines menschlichen oder tierischen Körpers zu reinigen oder zu behandeln.

16. Vorrichtung gemäß einem der vorherigen Ansprüche, wobei das erste und das zweite Gehäuse (11, 15) nebeneinander angeordnet sind.

17. Vorrichtung gemäß einem der vorherigen Ansprüche,
wobei das erste und das zweite Gehäuse (11, 15) durch eine gemeinsame Trennwand voneinander getrennt sind.

18. Vorrichtung gemäß einem der vorherigen Ansprüche,
wobei das erste Gehäuse (11) einen Lüfter (31) aufweist.

19. Vorrichtung gemäß einem der vorherigen Ansprüche,
wobei die Vorrichtung eine Gasversorgung aufweist, die dazu ausgestaltet ist, ein gasförmiges Prozessmedium zu dem piezoelektrischen Transformator (1) zu leiten.

20. Vorrichtung gemäß dem vorherigen Anspruch,
wobei die Gasversorgung in dem zweiten Gehäuse (15) integriert ist.

21. Vorrichtung gemäß Anspruch 19 oder 20,
wobei die Gasversorgung einen Druckminderer und/oder einen Massendurchflussregler aufweist, der es ermöglicht, die Menge des Prozessmediums zu regeln.

22. Vorrichtung gemäß einem der vorherigen Ansprüche,
wobei in ein Kabel (17), das das erste Gehäuse (11) mit dem zweiten Gehäuse (15) verbindet, ein Schlauch integriert ist, über den ein gasförmige Prozessmedium in das erste Gehäuse (11) eingeleitet wird.

23. Vorrichtung gemäß einem der vorherigen Ansprüche,
wobei der Eingangsbereich (2) des piezoelektrischen Transformators (11) auf einem ersten Stützelement (18) aufliegt,
wobei die Vorrichtung zumindest einen Vorsprung (36) aufweist, der einen Abstand zu dem piezoelektrischen Transformtor (1) aufweist, wenn der Transformator (1) sich in einem Ruhezustand befindet, und der einen Anschlag gegen Querbewegungen des piezoelektrischen Transformators (1) bildet.

24. Vorrichtung gemäß dem vorherigen Anspruch,
wobei der Vorsprung (36) auf halber Länge des piezoelektrischen Transformators (1) angeordnet ist.

25. Vorrichtung gemäß einem der Ansprüche 23 bis 24,
wobei die Vorrichtung einen zweiten Vorsprung (37) aufweist, der einen Abstand zu dem piezoelektrischen Transformtor (1) aufweist, wenn der piezoelektrische Transformator (1) sich in einem Ruhezustand befindet, und der einen Anschlag gegen Querbewegungen des piezoelektrischen Transformators (1) bildet, wobei der zweite Vorsprung (37) an einem eingangsseitigen Ende des Transformators (1) angeordnet ist.
